(19) Europäisches Patentamt
European Patent Office
Office européen des brevets

(11) EP 1 276 236 B1

(12) **EUROPEAN PATENT SPECIFICATION**

(45) Date of publication and mention of the grant of the patent:
**11.09.2013 Bulletin 2013/37**

(51) Int Cl.:
***H03H 9/64*** *(2006.01)*

(21) Application number: **02015358.1**

(22) Date of filing: **10.07.2002**

(54) **Inter-digital transducer, surface acoustic wave filter and communication apparatus using the same**

Interdigitaler Wandler, akustisches Oberflächenwellenfilter und diesen Wandler verwendendes Kommunikationsgerät

Transducteur interdigital, filtre à ondes acoustiques de surface et appareil de communication utilisant celui-ci

(84) Designated Contracting States:
**DE GB**

(30) Priority: **11.07.2001 JP 2001211345**
**23.05.2002 JP 2002149802**

(43) Date of publication of application:
**15.01.2003 Bulletin 2003/03**

(73) Proprietor: **Panasonic Corporation**
**Kadoma-shi**
**Osaka 571-8501 (JP)**

(72) Inventors:
- **Nakamura, Hiroyuki**
**Katano-shi,**
**Osaka 576-0016 (JP)**
- **Yamada, Toru**
**Katano-shi,**
**Osaka 576-0033 (JP)**
- **Tsuzuki, Shigeru**
**Neya gawa-shi,**
**Osaka 572-0054 (JP)**
- **Mita, Narihiro**
**Hirakata-shi,**
**Osaka 573-0071 (JP)**

(74) Representative: **Grünecker, Kinkeldey,**
**Stockmair & Schwanhäusser**
**Leopoldstrasse 4**
**80802 München (DE)**

(56) References cited:
**EP-A- 0 809 357**
**EP-A- 0 921 636**
**EP-A- 0 957 577**
**WO-A-01/13514**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

BACKGROUND OF THE INVENTION

Field of the Invention

The present invention relates to an inter-digital transducer provided with a balanced type terminal, a longitudinally coupled mode type surface acoustic wave filter and a communication apparatus using the same.

Description of the Related Art

As the electromechanical function parts using surface acoustic wave (SAW) have been noted with attention in the current of making the hardware high density because the acoustic velocity of wave is several kilometers/second, and the wave energy has properties to be concentrated on the surface of the propagation medium. Due to the development of inter-digital transducer (IDT) electrode and progress of the thin filmpreparing technique and surface processing technique, the SAW has been practically utilized for delay line for radar, band-pass filter for television receiver, etc. At present, the SAW is extensively used as RF and IF stage filters for receiving and transmitting circuits in radio-communication apparatus.

Conventionally, there are known transversal SAW filter and two kinds of longitudinally coupled mode coupled and transverse mode coupled type SAW filters. The transversal SAW filter has small group delay variation characteristic, but it has large insertion loss and large element size. On the other hand, the mode coupled type SAW filter presents steep attenuation characteristic, shows small insertion loss, and is small in element size, but its group delay variation characteristic is inferior to that of transversal type SAW filter. The longitudinally coupled mode type SAW filter is characterized by having relatively wide pass band, and the transverse mode type SAW filter is characterized by having very narrow pass band characteristic. In view of the above characteristics, as the RF filter for the mobile communication apparatus, the longitudinally coupledmode coupled type filter, and as the IF filter, the transverse mode coupled type SAW filters which is miniature in size and excellent in attenuation characteristic have been widely used.

Furthermore, balancing of semiconductor parts such as IC has advanced in recent years in order to reduce noise characteristics and balancing is also required for surface acoustic wave filters used for the RF stage. Furthermore, from the standpoint of impedance matching with ICs placed before and after, control over impedance of surface acoustic wave is required in recent years.

A surface acoustic wave filter used for the RF stage will be explained first as a first conventional technology.

A longitudinally coupled mode type surface acoustic wave filter having a conventional balanced type input/ output terminals will be explained below.

FIG. A12 shows a configuration of a longitudinally coupled mode type surface acoustic wave filter having conventional balanced type input/output terminals. In FIG. A12, the surface acoustic wave filter is constructed by forming input IDT electrodes 3002a and 3002b, reflector electrodes 3003a and 3003b and output IDT electrode 3004 on a piezoelectric substrate 3001. The electrode fingers of the input IDT electrodes 3002a and 3002b on the same side are connected to an input terminal S and the other fingers are grounded. Furthermore, the upper electrode digit of the output IDT electrode 3004 is connected to one output terminal T1 and the lower electrode digit of the output IDT electrode 3004 is connected to the other output terminal T2. By adopting the above-described configuration, a surface acoustic wave filter having balanced type output terminals is obtained.

Then, a surface acoustic wave filter used for the IF stage will be explained as a second conventional technology.

A conventional transversal mode coupled type surface acoustic wave filter will be explained below.

FIG. B24 is a block diagram showing a transversal mode coupled resonator type surface acoustic wave filter according to a conventional technology. In FIG. B24, reference numeral 241 denote a single crystal piezoelectric substrate and by forming an electrode pattern on this piezoelectric substrate 241, it is possible to excite surface acoustic wave. Reference numeral 242a denotes an IDT electrode formed on the piezoelectric substrate 241 and reflector electrodes 242b and 242c are placed on both sides of the IDT electrode forming thereby an energy-containment type surface acoustic wave resonator. Furthermore, an IDT electrode 243a, reflector electrodes 243b and 243c form a similar surface acoustic wave resonator on the piezoelectric substrate 241. These two resonators are placed close to each other and a surface acoustic wave filter is formed by generating acoustic coupling between these resonators.

In the surface acoustic wave filter configured as shown above, two kinds of surface acoustic wave mode frequencies to be excited on the piezoelectric substrate are determined according to the aperture length of the electrode fingers of the IDT electrodes and the distance between the two surface acoustic wave resonators placed close to each other and the passing bandwidth of the filter is determined.

However, the surface acoustic wave filters explained in the first and second conventional technologies are required to have impedance matching with IC elements in the preceding and following stages, and since the input/ output impedance of the above- described conventional filters is dependent on the number of pairs of electrode fingers included in the IDT electrodes and aperture length closely associated with the filter characteristic, there is a problem that it is difficult to attain a desired filter characteristic and a desired impedance value simultaneously.

In view of the above-described problems, the present invention has as its object to provide an inter-digital transducer, a surface acoustic wave filter having an optimal balancing and controlling input/output impedance and communication apparatus using it.

In view of the above-described problems, it is another object of the present invention to provide an inter-digital transducer, a surface acoustic wave filter having desired input/output impedance and communication apparatus using it.

EP 0 809 357 discloses a surface acoustic wave filter and multistage surface acoustic wave filter with a balanced type input and output constitution with low insertion loss, and with a wide pass band width, in which a desired input and output impedance can be obtained. A lower electrode resistance of the IDT electrodes is obtained by providing two surface acoustic resonators close to each other, such that directions of propagation of the surface acoustic waves are parallel and acoustically coupled, and providing leading out electrodes from at least two places of the inside bus bar.

SUMMARY OF THE INVENTION

The 1st invention of the present invention is an inter-digital transducer comprising:

a piezoelectric substrate; and
an IDT (inter-digital transducer) electrode having a pair of upper bus bar electrode and lower bus bar electrode placed facing each other on said piezoelectric substrate and a plurality of electrode fingers placed on said piezoelectric substrate each being led out from either said upper bus bar electrode or said lower bus bar electrode toward the other bus bar electrode,
wherein said IDT electrode is constructed of a plurality of divisional IDT electrodes and connected to a balanced type terminal, and
wherein at least two of said plurality of divisional IDT electrodes are equivalently connected in series and at least one of the remaining divisional IDT electrodes is connected in parallel with said at least two divisional IDT electrodes, and
wherein said plurality of divisional IDT electrodes is constructed of first, second and third divisional IDT electrodes.

The 2nd implementation of the present invention is the inter-digital transducer according to 2nd invention, wherein the ratio in the number of electrode fingers among said plurality of divisional IDT electrodes is adjusted beforehand so as to have a predetermined impedance value.

The 3rd implementation of the present invention is the inter-digital transducer according to 3rd invention, wherein said plurality of divisional IDT electrodes is placed in an same/reverse phase relationship so that charges of the divisional IDT electrodes do not cancel out each other.

The 4th implementation of the present invention is the inter-digital transducer according to 1st implementation of the invention,
wherein said second divisional IDT electrode is placed in in same phase relationship between said first divisional IDT electrode and said third divisional IDT electrode,
the part of said upper bus bar electrode corresponding to said first divisional IDT electrode and the part of said upper bus bar electrode corresponding to said second divisional IDT electrode are connected to one end of said balanced type terminal, and the part of said lower bus bar electrode corresponding to said second divisional IDT electrode and the part of said lower bus bar electrode corresponding to said third divisional IDT electrode are connected to the other end of said balanced type terminal.

The 6th implementation of the present invention is the inter-digital transducer according to 4th invention, wherein said plurality of divisional IDT electrodes is constructed of first, second, third and fourth divisional IDT electrodes. The 7th implementation of the present invention is the inter-digital transducer according to 16th invention,
wherein said plurality of divisional IDT electrodes is placed in order of said first, second, third and fourth divisional IDT electrodes,
the part of said upper bus bar electrode corresponding to said first divisional IDT electrode, the part of said upper bus bar electrode corresponding to said third divisional IDT electrode and the part of said upper bus bar electrode corresponding to said fourth divisional IDT electrode are connected, and
the part of said lower bus bar electrode corresponding to said first divisional IDT electrode, the part of said lower bus bar electrode corresponding to said second divisional IDT electrode and the part of said lower bus bar electrode corresponding to said fourth divisional IDT electrode are connected.

The 8th implementation of the present invention is the inter-digital transducer according to 18th invention, wherein of said plurality of electrode fingers, substantially all adjacent pairs of electrode fingers are in an same phase relationship and substantially all of the plurality of electrode fingers is connected so that respective charges do not cancel out each other.

The 9th implementation of the present invention is the inter-digital transducer according to 17th invention, wherein the part of said upper bus bar electrode corresponding to said second IDT electrode is grounded and the part of said lower bus bar electrode corresponding to said third IDT electrode is grounded.

The 10st implementation of the present invention is the inter-digital transducer according to 17th invention, wherein the part of said upper bus bar electrode corresponding to said second IDT electrode is connected to the part of said lower bus bar electrode corresponding to said third IDT electrode.

The 11nd implementation of the present invention is the inter-digital transducer according to 21st invention, wherein said "connection" means that, of adjacent electrode fingers of said second divisional IDT electrode and said third divisional IDT electrode, said second divisional IDT electrode digit is connected to both the part of said upper electrode corresponding to said second divisional IDT electrode and the part of said lower electrode corresponding to said third divisional IDT electrode, and
of adjacent electrode fingers said third divisional IDT electrode digit is connected to both the part of said lower electrode corresponding to said third divisional IDTelectrode and the part of said upper electrode corresponding to said second divisional IDT electrode.

The 12th implementation of present invention is the surface acoustic wave filter according to 24th invention, wherein said three IDT electrodes are first, second and third IDT electrodes,
said second IDT electrode and said third IDT electrode are placed on both sides of said first IDT electrode respectively, said reflector electrodes are placed opposite said first IDT electrode of said second IDT electrode and opposite said first IDT electrode of said third IDT electrode respectively, and
said first IDT electrode is the IDT electrode of said inter-digital transducer.

The 26th invention of the present invention is the surface acoustic wave filter according to 25th invnetion, wherein the upper bus bar electrode of said second IDT electrode is connected to an unbalanced type terminal and the lower bus bar electrode is grounded and the lower bus bar electrode of said third IDT electrode is connected to said unbalanced type terminal and the upper bus bar electrode is grounded.

The 14th implementation of the present invention is a surface acoustic wave filter comprising:

a piezoelectric substrate;
a plurality of longitudinally coupled mode type surface acoustic wave filters having a plurality of IDT electrodes and a plurality of reflector electrodes placed on said piezoelectric substrate,
wherein said plurality of surface acoustic wave filters are connected in multiple stages,
of said plurality of surface acoustic wave filters, at least the surface acoustic wave filters on the input side and/or the surface acoustic wave filters on the output side are the surface acoustic wave filters according to 24th invention, and
said piezoelectric substrates of at least the surface acoustic wave filters on the input side and/or the surface acoustic wave filters on the output side of said plurality of surface acoustic wave filters are the piezoelectric substrates of the surface acoustic wave filters according to 24th invention.

The 15th implementation of the present invention is the surface acoustic wave filter according to 14th implementation of the invention,
wherein said plurality means 2,
saidplurality of acoustic wave filters area first surface acoustic wave filter and a second surface acoustic wave filter,
said first and second surface acoustic wave filters each comprise at least three IDT electrodes,
said first and second surface acoustic wave filters are connected in cascade form,
said first and second surface acoustic wave filters are connected at two points using at least two IDT electrodes, and the phase of one signal of said IDT electrode is opposite the phase of the other signal of said IDT electrode.

The 16th implementation of the present invention is a surface acoustic wave filter comprising:

a piezoelectric substrate;
two IDT (inter-digital transducer) electrodes having a pair of upper bus bar electrode and lower bus bar electrode facing each other placed on said piezoelectric substrate and a plurality of electrode fingers each being led out from either said upper bus bar electrode or said lower bus bar electrode toward the other bus bar electrode; and
a plurality of reflector electrodes,
said surface acoustic wave filter being a longitudinally coupled mode type surface acoustic wave filter in which said two IDT electrodes and said plurality of reflector electrodes are placed in the propagation directions of surface acoustic waves respectively,
wherein at least one of said two IDT electrodes is the IDT electrode of the inter-digital transducer according to 5th invention,
the part of said upper bus bar electrode of said IDT electrode of said inter-digital transducer corresponding to said first divisional IDT electrode and/or the part of said upper bus bar electrode of said IDT electrode corresponding to said second divisional IDT electrode are connected to one end of said balanced type terminal of said inter-digital transducer,
the part of said lower bus bar electrode of said IDT electrode of said inter-digital transducer corresponding to said second divisional IDT electrode and/or the part of said lower bus bar electrode of said IDT electrode corresponding to said third divisional IDT electrode are connected to the other end of said balanced type terminal, and
said piezoelectric substrate is the piezoelectric substrate of said inter-digital transducer.

The 17th implementation of the present invention is a surface acoustic wave filter comprising:

a piezoelectric substrate;
five IDT (inter-digital transducer) electrodes having a pair of upper bus bar electrode and lower bus bar electrode facing each other placed on said piezoelectric substrate and a plurality of electrode fingers each being led out from either said upper bus bar electrode or said lower bus bar electrode toward the other bus bar electrode; and
at least two reflector electrodes,
said surface acoustic wave filter being a longitudinally coupled mode type surface acoustic wave filter in which said five IDT electrodes and said plurality of reflector electrodes are placed in the propagation directions of surface acoustic waves respectively,
wherein at least one of said five IDT electrodes is the IDT electrode of the inter-digital transducer according to 5th invention,

The 18th implementation of the present invention is a communication apparatus comprising:

a transmission circuit that outputs transmission waves; and
a reception circuit that receives reception waves,
wherein the surface acoustic wave filter used for said transmission circuit and/or said reception circuit is the surface acoustic wave filter according to 23rd invention.

BRIEF DESCRIPTION OF THE DRAWINGS

FIG. 1 is a block diagram of an inter-digital transducer according to Embodiment 1 of the present invention;
FIG. 2 is another block diagram of the inter-digital transducer according to the prior art;
FIG. 3 is a block diagram of a surface acoustic wave filter according to Embodiment A1 of the present invention;
FIG. 4 illustrates a capacitance equivalent circuit of the surface acoustic wave filter according to Embodiment A1 of the present invention;
FIG. 5 is a block diagram of a surface acoustic wave filter having a pad electrode according to Embodiment A1 of the present invention;
FIG. 6 is another block diagram of the surface acoustic wave filter according to Embodiment A1 of the present invention;
FIG. 7 is a block diagram of at surface acoustic wave filter according to Embodiment A2 of the present invention;
FIG. 8 is a block diagram of a surface acoustic wave filter according to Embodiment A3 of the present invention;
FIG. 9a is a passing characteristic of a surface acoustic wave filter before the division according to Embodiment A3 of the present invention;
FIG. 9b is a passing characteristic of a surface acoustic wave filter after the division according to Embodiment A3 of the present invention;
FIG. 10 is another block diagram of the surface acoustic wave filter according to Embodiment A3 of the present invention;
FIG. 11 is another block diagram of the surface acoustic wave filter according to Embodiment A3 of the present invention;
FIG. 12 is another block diagram of the surface acoustic wave filter according to Embodiment A1 of the present invention;
FIG. 13 is another block diagram of the surface acoustic wave filter according to Embodiment A1 of the present invention;
FIG. 14 is a block diagram of a conventional surface acoustic wave filter;

FIG. 15 is a block diagram of a surface acoustic wave filter according to Embodiment A4 of the present invention;
FIG. 16 illustrates a capacitance equivalent circuit of the surface acoustic wave filter according to Embodiment A4 of the present invention;
FIG. 17 is a block diagram of a surface acoustic wave filter according to Embodiment A5 of the present invention;
FIG. 18 illustrates a capacitance equivalent circuit of the surface acoustic wave filter according to Embodiment A5 of the present invention;
FIG. 19 illustrates a configuration of a communication apparatus according to Embodiment A6 of the present invention;
FIG. 20 illustrates an electrode pattern of a conventional surface acoustic wave filter.

[Description of Symbols]

2101 PIEZOELECTRIC SUBSTRATE
2102a, 2102b INPUT IDT ELECTRODE
2103a, 2103b REFLECTOR ELECTRODE
2104 OUTPUT IDT ELECTRODE
2104a FIRST DIVISIONAL IDT ELECTRODE
2104b SECOND DIVISIONAL IDT ELECTRODE
2104c THIRD DIVISIONAL IDT ELECTRODE
2105a, 2105b, 2105c UPPER ELECTRODE
2106a, 2106b, 2106c LOWER ELECTRODE
2301 INPUT SIDE PAD ELECTRODE
2303a FIRST OUTPUT SIDE PAD ELECTRODE
2303b SECOND OUTPUT SIDE PAD ELECTRODE
2302a, 2302b ROUTING WIRING
2501 PIEZOELECTRIC SUBSTRATE
2502a, 2502b INPUT IDT ELECTRODE
2503a, 2503b REFLECTOR ELECTRODE
2504 OUTPUT IDT ELECTRODE
2504a, 2504b, 2504c DIVISIONAL IDT ELECTRODE
2505a, 2505b, 2505c UPPER ELECTRODE
2506a, 2506b, 2506c LOWER ELECTRODE
2601 PIEZOELECTRIC SUBSTRATE
2602a, 2602b REFLECTOR ELECTRODE
2603 IDT ELECTRODE
2604 SURFACE ACOUSTIC WAVE RESONATOR
2605a, 2605b REFLECTOR ELECTRODE
2606 IDT ELECTRODE
2607 SURFACE ACOUSTIC WAVE RESONATOR
2801 SURFACE ACOUSTIC WAVE RESONATOR
2802 FIRST-STAGE SURFACE ACOUSTIC WAVE FILTER
2803 INPUT IDT ELECTRODE
2804a, 2804b REFLECTOR ELECTRODE
2805a, 2805b OUTPUT IDT ELECTRODE
2806 SECOND-STAGE SURFACE ACOUSTIC WAVE FILTER
2901 PIEZOELECTRIC SUBSTRATE
2902 FIRST-STAGE SURFACE ACOUSTIC WAVE FILTER
2903 INPUT IDT ELECTRODE
2904a, 2904b REFLECTOR ELECTRODE
2905a, 2905b OUTPUT IDT ELECTRODE
2906 SECOND-STAGE SURFACE ACOUSTIC WAVE FILTER
2502a, 2502b INPUT IDT ELECTRODE
2504 OUTPUT IDT ELECTRODE

DESCRIPTION OF THE PREFERRED EMBODIMENTS

With reference now to the attached drawings, embodiments of the present invention will be explained below.

(Embodiment 1)

First, only an outline of the inter- digital transducer (hereinafter referred to as "IDT electrode") according to Embodiment 1 of the present invention will be explained.

Details thereof will be explained in respective embodiments of group A and group B below.

FIG. 1 shows an IDT electrode 2104 according to Embodiment 1 of the present invention. The IDT electrode 2104 is placed on a piezoelectric substrate 2101 and is an electrode that converts a surface acoustic wave propagating on the piezoelectric substrate to an electric signal and converts an electric signal to a surface acoustic wave propagating on the piezoelectric substrate.

The IDT electrode 2104 is divided into three portions, first, second and third divisional IDT electrodes 2104a, 2104b and 2104c and constructed by connecting the three groups of divisional IDT electrodes 2104a, 2104b and 2104c.

Here, the first divisional IDT electrode 2104a, second divisional IDT electrode 2104b and third divisional IDT electrode 2104c are placed in such a way as to be same phase with one another. Furthermore, upper electrodes 2105a and 2105b of the first and second divisional IDT electrodes 2104a and 2104b are electrically connected and also connected to one end T1 of a balanced type output terminal. Furthermore, lower electrodes 2106b and 2106c of the second and third divisional IDT electrodes 2104b and 2104c are electrically connected and also connected to the other end T2 of the balanced type output terminal. Furthermore, the lower electrode 2106a of the first divisional IDT electrode 2104a and the upper electrode 2105c of the third divisional IDT electrode 2104c are grounded.

Then, an operation of this embodiment will be explained.

The IDT electrode 2104 converts a surface acoustic wave propagating on the piezoelectric substrate to an electric signal and outputs to the balanced type output terminals T1 and T2.

On the contrary, it is also possible to use the balanced type output terminals T1 and T2 as input terminals. In this case, the IDT electrode 2104 converts an electric signal input from **T1** or T2 to a surface acoustic wave propagating on the piezoelectric substrate 2101.

Thus, the IDT electrode 2104 of this embodiment can convert an electric signal to a surface acoustic wave and convert a surface acoustic wave to an electric signal.

This embodiment is characterized in that when the IDT electrode 2104 of this embodiment is divided into the first divisional IDT electrode 2104a, second divisional IDT electrode 2104b and third divisional IDT electrode 2104c and the ratio of the number of electrode fingers between the first, second and third divisional IDT electrodes 2104a, 2104b and 2104c is changed, impedance values at T1 and T2 change, whereas the frequency characteristic of the IDT electrode 2104 does not mostly change.

Therefore, when a predetermined frequency characteristic is obtained by adjusting the number and width of the electrode fingers and center distance between the electrode fingers of the IDT electrode 2104, it is possible to change only impedance without substantially changing the acquired predetermined frequency characteristic by simply adjusting the ratio of the number of electrode fingers between the first, second and third divisional IDT electrodes 2104a, 2104b and 2104c of the IDT electrode 2104 while fixing the number and width of the electrode fingers and center distance between the mutually adjacent electrode fingers, etc. Thus, the IDT electrode 2104 of this embodiment has an excellent feature of being capable of controlling impedance.

On the other hand, FIG. 2 illustrates an IDT electrode 183a known from the prior art which differs from the IDT electrode 2104 in the layout of electrode fingers, etc. As in the case of the IDT electrode 2104 in FIG. 1, the IDT electrode 183a is divided into three portions of first, second, third divisional IDT electrodes 184a, 184b and 184c and is constructed by connecting the three groups of the divisional IDT electrodes 184a, 184b and 184c.

Therefore, the IDT electrode 183a in FIG. 2 also has an excellent feature of being capable of controlling impedance in the same way as the IDT electrode 2104 in FIG. 1.

Then, of the embodiments of the present invention, the embodiments of group A will be explained below.

(Embodiment A1)

First, Embodiment A1 of the present invention will be explained.

FIG. 3 is a schematic view of a surface acoustic wave filter according to Embodiment A1.

In FIG. 3, reference numeral 2101 denotes a piezoelectric substrate and it is possible to excite a surface acoustic wave by constructing electrode patterns crossing in strip-line form with a cyclic structure on this piezoelectric substrate 2101. A longitudinally coupledmode type surface acoustic wave filter comprising input IDT electrodes 2102a and 2102b, reflector electrodes 2103a and 2103b and an output IDT electrode 2104 is formed on the piezoelectric substrate 2101.

Each IDT electrode consists of a pair of mutually facing comb-like electrodes and each comb-like electrode consists of electrode fingers and electrodes (upper electrode and lower electrode) from which these electrode fingers are led out.

In the above-described surface acoustic wave filter, the upper electrodes of the input IDT electrodes 2102a and 2102b are connected to an input terminal S and the lower electrodes of the input IDT electrodes 2102a and 2102b are grounded.

Furthermore, the output IDT electrode 2104 is divided into three portions, first, second and third divisional IDT electrodes 2104a, 2104b and 2104c and constructed by connecting the three groups of divisional IDT electrodes 2104a, 2104b and 2104c. Here, the first divisional IDT electrode 2104a, second divisional IDT electrode 2104b and third divisional IDT electrode 2104c are placed in such a way as to be same phase with one another. Furthermore, upper electrodes 2105a and 2105b of the first and second divisional IDT electrodes 2104a and 2104b are electrically connected and also connected to one end T1 of a balanced type output terminal. Furthermore, lower electrodes 2106b and 2106c of the second and third divisional IDT electrodes 2104b and 2104c are electrically connected and also connected to the other end T2 of the balanced type output terminal. Furthermore, the lower electrode 2106a of the first divisional IDT electrodes 2104a and the lower electrode 2106c of the third divisional IDT electrodes 2104c are grounded.

Here, the above- described same phase will be explained.

First, a structural positional relationship between the two adjacent electrode fingers (that is, a pair of adjacent electrode fingers) will be explained.

That is, that the two adjacent electrode fingers are in an same phase relationship means that the two adjacent electrode fingers are in such a connection relationship that one of the two electrode fingers is connected to the upper electrode and extends downward and the other electrode digit is connected to the lower electrode and extends upward. Here, suppose that the charge of the upper electrode is different from that of the lower electrode. Also suppose that the pitch between the two adjacent electrode fingers (center distance) is $1/2 \times \lambda$. Here, the above-described pitch between the electrode fingers may also be $(m+1/2) \times \lambda$.

On the other hand, if the above-described pitch between the electrode fingers is $(m+1/2) \times \lambda$, then the above-described. same phase relationship is completely opposite the same phase relationship described above. That is, that the two adjacent electrode fingers are in an same phase relationship means that the pitch between the electrode fingers is $(m+1) \times \lambda$ and both electrode fingers are connected to the upper electrode or that the pitch between the electrode fingers is $(m+1) \times \lambda$ and both electrode fingers are connected to the lower electrode. Here, $\lambda$ denotes the wavelength of an excited surface acoustic wave and m=0, 1, 2, 3, ...

As described above, the upper electrodes 2105a and 2105b of the first and second divisional IDT electrodes 2104a and 2104b are electrically connected and also connected to one end T1 of the balanced type output terminal and the lower electrodes 2106b and 2106c of the second and third divisional IDT electrodes 2104b and 2104c are electrically connected and also connected to the other end T2 of the balanced-type output terminal. In this way, since the one end T1 and the other end T2 of the balanced type output terminal are connected to the upper and lower sides opposite each other, in the case where both of the above-described two adjacent electrode fingers in an same phase relationship are led out from the upper electrode or lower electrode both of which are connected to the balanced type terminals, their respective positive and negative charges are reversed. Furthermore, in the case where either of the above-described two adjacent electrode fingers in an same phase relationship is led out from the upper electrode or lower electrode connected to the balanced type terminal and the other is led out from the grounded upper electrode or lower electrode, the charge of the electrode digit led out from the grounded upper electrode or lower electrode does not cancel out the charge of the electrode digit led out from the upper electrode or lower electrode connected to the balanced type terminal. Therefore, in either case, these two electrode fingers can excite surface acoustic waves in such a way that surface acoustic waves do not cancel out each other.

The same also applies to the case of an IDT electrode with a pair of balanced type terminals such as the IDT electrode 183a in FIG. B18 of Embodiment B5 connected to either the upper side or lower side of the IDT electrode.

Furthermore, all electrode fingers are assumed to be substantially same phase, and this means that some electrode fingers maybe placed at different locations due to withdrawing, etc. and that any configuration is acceptable if the electrode fingers as a whole at least allow surface acoustic waves to be excited.

This applies not only to Embodiment A1 but also to Embodiment 1 and Embodiment A1 and subsequent embodiments.

Furthermore, this embodiment has such a configuration that the adj acent electrode fingers of the input IDT electrode 2102a and divisional IDT electrode 2104a are led out from the lower electrodes in the same direction and the adjacent electrode fingers of the input IDT electrode 2102b and divisional IDT electrode 2104c are led out from the upper electrodes in the same direction, but this positional relationship may change depending on the number of electrode fingers, etc. and any positional relationship different from this positional relationship may also be adopted if it at least allows surface acoustic waves to be excited without being cancelled out:

Here, the input IDT electrodes 2102a and 2102b and output IDT electrode 2104 are examples of the IDT electrodes of the present invention, and the respective upper electrodes and lower electrodes of input IDT electrodes 2102a and 2102b and output IDT electrode 2104 are examples of the upper bus bar electrodes and lower bus bar electrodes of the present invention.

An operation of the surface acoustic wave filter of Embodiment A1 configured as shown above will be explained below.

FIG. 4 is a capacitance equivalent circuit diagram of Embodiment A1. Reference characters Ca, Cb and Cc denote capacitances of the first, second and third divisional IDT electrodes 2104a, 2104b and 2104c respectively and a total capacitance of Ca, Cb and Cc constitutes a total capacitance Cout of the output IDT electrode 2104 and is expressed in the following expression. That is, the first divisional IDT electrode 2104a and third divisional IDT electrode 2104c are connected in series, while the second divisional IDT electrode 2104b is connected in parallel with the first divisional IDT electrode 2104a and third divisional IDT electrode 2104c.

[Mathematical expression 1]

$$Cout = (Ca \cdot Cb + Cb \cdot Cc + Cc \cdot Ca) / (Ca + Cc)$$

where, the number of pairs of electrode fingers included in the output IDT electrode 2104 is N, the capacitance before being divided is C0, the numbers of pairs of electrode fingers of the first, second and third divisional IDT electrodes 2104a, 2104b and 2104c are Na, Nb and Nc. Then, the following expression is set up.

[Mathematical expression 1]

$$N = Na + Nb + Nc$$

$$C0 = Ca + Cb + Cc$$

$$Ca = (Ca + Cb + Cc) \times Na / (Na + Nb + Nc) = C0 \times Na / (Na + Nb + Nc)$$

$$Cb = (Ca + Cb + Cc) \times Nb / (Na + Nb + Nc) = C0 \times Nb / (Na + Nb + Nc)$$

$$Cc = (Ca + Cb + Cc) \times Nc / (Na + Nb + Nc) = C0 \times Nc / (Na + Nb + Nc)$$

Therefore, total capacitance Cout after the division is as follows.

[Mathematical expression 3]

$$Cout = C0 \times (Na \cdot Nb + Nb \cdot Nc + Nc \cdot Na) / \{(Na + Nc) \times N\}$$

Since the capacitances of the IDT electrodes are dominant in impedance of the surface acoustic wave filter, it is possible to control the total capacitance Cout of the input IDT electrode 2104 and control impedance by changing the number of pairs Na, Nb and Nc of the divisional IDT electrodes 2104a, 2104b and 2104c.

For example, impedance can be controlled as follows. First, the number of pairs N and pitch of electrode fingers, etc. of the input IDT electrode 2104 are determined in the design stage to obtain a desired filter characteristic. Then, while the numbers of pairs N of the input IDT electrode 2104 is fixed, the numbers of pairs Na, Nb and Nc of the divisional IDT electrodes 2104a, 2104b and 2104c are changed. In this way, it is possible to obtain impedance of the surface acoustic wave filter from Mathematical expression 3. Therefore, it is possible to determine Na, Nb and Nc using Mathematical expression 3 so that the desired impedance is obtained. Thus, it is known that the filter characteristic of the surface acoustic wave filter does not change significantly when the ratio between Na, Nb and Nc is changed while N is fixed. Thus, using the surface acoustic wave filter of this embodiment makes it possible to obtain a desired filter characteristic and control impedance so that desired impedance can be obtained.

For example, suppose the impedance of the output IDT electrode before the division is Z0 and capacitance is C0. If the numbers of pairs of the divisional IDT electrodes 2104a, 2104b and 2104c are equal, that is, Na = Nb = Nc, Cout becomes 1/2 $\times$ C0, that is, Cout is reduced by half compared to Cout before the division. Furthermore, as is apparent from mathematical expression 3, as the number of pairs Nb of the second divisional IDT electrode becomes smaller, Cout decreases and when the number of pairs Nb of the second divisional IDT electrode is reduced to zero, Cout becomes 1/4 $\times$ C0. That is, impedance is almost quadruple that before the division.

In this way, a longitudinally coupled mode type surface acoustic wave filter is obtained whose impedance is controllable by changing the ratio of the number of pairs among the divisional IDT electrodes.

Furthermore, mounting a surface acoustic wave filter requires a pad electrode so that it can be connected to input terminals or output terminals. FIG. 5 shows a schematic view of a surface acoustic wave filter having a pad electrode. A pad electrode 2301 on the input side is connected to the input IDT electrodes 2102a and 2102b via routing electrodes 2302a and 2302b. Furthermore, first and second pad electrode 2303a and 2303b on the output side are connected to the upper side and lower side of the output electrode. The first output side pad electrode 2303a is connected to the upper bus bar electrode 2105a of the first divisional IDT electrode 2104a and the upper bus bar electrode 2105b of the second divisional IDT electrode and the second output side pad electrode 2303b is connected to the lower bus bar electrode 2106b of the second divisional IDT electrode 2104b and the lower bus bar electrode 2106c of the third divisional IDT electrode 2104c. Thus, by preserving the structural symmetry of the balanced type terminals T1 and T2 on the output side, it is possible to implement a surface acoustic wave filter with an excellent balance characteristic.

By the way, connecting with the respective pad electrodes can be performed using wires or directly through face down mounting.

In FIG. 3, the divisional IDT electrode 2104a and divisional IDT electrode 2104c have the same number of electrode fingers and the adjacent electrode fingers of the input IDT electrode 2102a and divisional IDT electrode 2104a are led out from the lower bus bar electrodes in the same direction and the adjacent electrode fingers of the input IDT electrode 2102b and divisional IDT electrode 2104c are led out from the upper bus bar electrodes in the same direction. However, as shown in FIG. 6, even if the adjacent electrode fingers of the input IDT electrode 2102a and divisional IDT electrode 2104a are led out from their respective bus bar electrodes in directions crossing each other and the adjacent electrode fingers of the input IDT electrode 2102b and divisional IDT electrode 2104c are led out from their respectivebus barelectrodes in directions crossing each other, the characteristic as the surface acoustic wave filter can be obtained likewise as far as those electrodes are in such a positional relationship that surface acoustic waves are excited without canceling out each other.

If the first and third divisional IDT electrodes 2104a and 2104c have the same number of divided pairs and the divisional IDT electrode 2104b has the same number of upper and lower electrode fingers, the same number of IDT electrode digit pairs are connected to both balanced type output terminals. Adopting such a configuration provides a surface acoustic wave filter with excellent balancing.

This embodiment has described the case where the respective upper bus bar electrodes of the input IDT electrodes 2102a and 2102b are connected to the input terminal S and the respective lower bus bar electrodes of the input IDT electrodes 2102a and 2102b are grounded but this embodiment is not limited to this. As shown in FIG. 12, the upper bus bar electrode of the input IDT electrode 2102a and the lower bus bar electrode of the input IDT electrode 2102b may also be connected to the input terminal S and the lower bus bar electrode of the input IDT electrode 2102a and the upper bus bar electrode of the input IDT electrode 2102b may be grounded. Or on the contrary, the lower bus bar electrode of the input IDT electrode 2102a and the upper bus bar electrode of the input IDT electrode 2102b may also be connected to the input terminal S and the upper bus bar electrode of the input IDT electrode 2102a and the lower bus bar electrode of the input IDT electrode 2102b may be grounded. That is, the signal route from the input terminal S is connected structurally upside down. Furthermore, the electrode fingers of the input IDT electrodes 2102a and 2102b are placed in such a way that surface acoustic waves do not cancel out each other.

Furthermore, in FIG. 12, the adjacent electrode fingers of the input IDT electrode 2102a and divisional IDT electrode 2104a are led out from the upper bus bar electrode and lower bus bar electrode in directions crossing each other respectively and the adjacent electrode fingers of the input IDT electrode 2102b and divisional IDT electrode 2104c are led out from the upper bus bar electrode in the same directions, but this positional relationship varies depending on the number of electrode fingers, etc. and any positional relationship different from this positional relationship may also be used if it at least allows surface acoustic waves to be excited without canceling out each other.

Adopting such a configuration suppresses the deterioration of balancing due to spatial coupling between wiring lead out from the input IDT electrodes 2102a and 2102b connected to the input terminal S and wiring lead out from the IDT electrode 2104 connected to the output terminals T1 and T2 making it possible to obtain a surface acoustic filter having optimal balancing.

Moreover, this embodiment has explained that the divisional IDT electrodes are on the output side, but the divisional IDT electrodes can also be on the input side. In this case, the divisional IDT electrodes can control impedance on the input side.

Furthermore, this embodiment has explained that the output IDT electrode 2104 is divided into divisional IDT electrodes 2104a, 2104b and 2104c, but it is also possible to divide the input IDT electrode 2102a and/or input IDT electrode 2102b into divisional IDT electrodes to form a balanced type terminal configuration. In this case, both the input side and output side constitute balanced type terminals, making it possible to control impedance.

Furthermore, this embodiment has explained that the output IDT electrode 2104 is divided into three portions, divisional IDT electrodes 2104a, 2104b and 2104c, but it is also possible to divide the output IDT electrode 2104 into 4, 5 or more divisional IDT electrodes.

When the output IDT electrode 2104 is divided into two divisional IDT electrodes, that is, when the number of electrode fingers of the divisional IDT electrode 2104b is zero, it is possible to connect the upper electrode to the balanced type terminal T1 and connect the lower electrode to the balanced type terminal T2 and secure isolation between the balanced type terminals. That is, FIG. 13 shows a case where the output IDT electrode 2104 is divided into two divisional IDT electrodes. In FIG. 13, by adopting a configuration whereby the upper electrode of the input IDT electrode 2102a and the lower electrode of the input IDT electrode 2102b are connected to the unbalance type terminal S, it is possible to suppress deterioration of balancing due to spatial coupling between lead wiring of the input IDT electrode 2102a and T1 and between lead wiring of the input IDT electrode 2102b and T2.

This embodiment has described the case where the surface acoustic wave filter comprises a total of 3 IDT electrodes, that is, one output IDT electrode 2104 and two input IDT electrodes 2102a and 2102b, but this embodiment is not limited to this. The surface acoustic wave filter of this embodiment may also be constructed of two, five, seven or any number of IDT electrodes.

This embodiment has described the case where the upper electrodes 2105a and 2105b of the first and second divisional IDT electrodes 2104a and 2104b are electrically connected, but these upper electrodes may also be united into one common upper electrode. On the other hand, the lower electrodes 2106b and 2106c of the second and third divisional IDT electrodes 2104b and 2104c are electrically connected, but these lower electrodes may also be united into one common lower electrode. Moreover, as shown in FIG. 5, when the pad electrodes 2303a and 2303b are used, it is also possible to electrically connect the upper electrodes 2105a and 2105b of the first and second divisional IDT electrodes 2104a and 2104b via the pad electrode 2303a instead of directly electrically connecting them. Likewise, it is also possible to electrically connect the lower electrodes 2106b and 2106c of the second and third divisional IDT electrodes 2104b and 2104c via the pad electrode 2303b instead of directly electrically connecting them.

Furthermore, with regard to the method of grounding the upper electrode 2105c of the divisional IDT electrode 2104c and the lower electrode 2106a of the divisional IDT electrode 2104a, it is also possible to provide independent grounding apart from the grounding electrodes of the input IDT electrodes 2102a and 2102b or instead of actually grounding the upper electrode 2105c of the divisional IDT electrode 2104c and the lower electrode 2106a of the divisional IDT electrode 2104a, it is also possible to electrically connect them thereby providing virtual grounding. The case of virtual grounding is equivalent to a configuration of the capacitance equivalent circuit in FIG. A2 without grounding. In these cases, it is possible to suppress deterioration of the characteristic due to routing of the signal from GND.

Furthermore, since this embodiment adopts an unbalanced type for the input side and a balanced type for the output side, the surface acoustic wave filter of this embodiment also assumes the role of conversion between balance and unbalance. That is, the surface acoustic wave filter of this embodiment can also function as a balun.

As shown above, the surface acoustic wave filter of this embodiment can not only have a balanced type terminal but also control input/output impedance of the surface acoustic wave filter.

(Embodiment A2)

The surface acoustic wave filter according to Embodiment A2 of the present invention will be explained below with reference to the attached drawings. FIG. 7 is a schematic view of the surface acoustic wave filter according to Embodiment A2.

In FIG. 7, reference numeral 2501 denotes a piezoelectric substrate and it is possible to excite a surface acoustic wave by constructing comb-like electrode patterns crossing in strip-line form with a cyclic structure on this piezoelectric substrate 2501. A longitudinally coupled mode type surface acoustic wave filter comprising input IDT electrodes 2502a and 2502b, reflector electrodes 2503a and 2503b and an output IDT electrode 2504 is formed on the piezoelectric substrate 2501.

In the above-described surface acoustic wave filter, the upper electrode of the input IDT electrode 2502a is connected to one input terminal S1 and the upper electrode of the input IDT electrode 2502b is connected to the other input terminal S2 and the lower electrodes of the input IDT electrodes 2502a and 2502b are grounded. This embodiment A2 is different from Embodiment A1 in that the input IDT electrodes 2502a and 2502b are of a balanced type.

Furthermore, S1 and S2 constitute balanced type terminals and the signals input from S1 and S2 to the input IDT electrodes 2502a and 2502b have phases opposite each other. Furthermore, the adjacent electrode fingers of the input IDT electrode 2502a and the divisional IDT electrode 2504a are led out from the lower bus bar electrode and upper bus bar electrode in directions crossing each other and the adjacent electrode fingers of the input IDT electrode 2502b and the divisional IDT electrode 2504c are led out from the upper bus bar electrodes in the same directions. This positional relationship varies depending on the number of electrode fingers and a positional relationship different from this positional relationship may also be used as far as it at least allows surface acoustic waves to be excited without canceling out each other.

Furthermore, the output IDT electrode 2504 is constructed of three groups, first, second and third divisional IDT electrodes 2504a, 2504b and 2504c. Here, the first divisional IDT electrode 2504a, second divisional IDT electrode 2504b and third divisional IDT electrode 2504c are placed same phase with one another. The upper electrodes 2505a and 2505b of the first and second divisional IDT electrodes 2504a and 2504b are electrically connected and also connected to one terminal T1 of the balance type output terminal. The lower electrodes 2506b and 2506c of the second and third divisional IDT electrodes 2504b and 2504c are electrically connected and also connected to the other end T2 of the balanced type output terminal. The lower electrode 2506a of the first divisional IDT electrode 2504a and the lower electrode 2506c of the third divisional IDT electrode 2504c are grounded.

The surface acoustic wave filter according to Embodiment A2 configured as shown above is different from Embodiment A1 only in the balanced type input terminals and the locations of the input IDT electrodes, and the same in the method of division, operation and effects of the output IDT electrodes.

Furthermore, since signals to the input IDT electrodes 2502a and 2502b in the above configuration have phases opposite each other, it is possible to suppress characteristic deterioration due to spatial coupling and reduce deterioration of balancing due to direct coupling between the input IDT 2502a and 2502b and output IDT 2504.

This embodiment assumes that the upper electrodes 2505a and 2505b of the first and second divisional IDT electrodes 2504a and 2504b are electrically connected, but the respective upper electrodes may also be united into one common upper electrode. Furthermore, this embodiment also assumes that the lower electrodes 2506b and 2506c of the second and third divisional IDT electrodes 2504b and 2504c are electrically connected, but the respective upper electrodes may also be united into one common lower electrode. Furthermore, when a pad electrode is used as in the case of Embodiment A1, instead of directly electrically connecting the upper electrodes 2505a and 2505b of the first and second divisional IDT electrodes 2504a and 2504b, it is possible to electrically connect the upper electrodes 2505a and 2505b via the pad electrode as in the case of Embodiment A1. Likewise, instead of directly electrically connecting the lower electrodes 2506b and 2506c of the second and third divisional IDT electrodes 2504b and 2504c, it is possible to electrically connect the lower electrodes 2506b and 2506c via the pad electrode as in the case of Embodiment A1.

Furthermore, with respect to the method of grounding the upper electrode 2505c of the divisional IDT electrode 2504c and the lower electrode 2506a of the divisional IDT electrode 2504a, it is also possible to independently ground them apart from the grounding electrodes of the input IDT electrodes 2502a and 2502b or electrically connect the upper electrode 2505c of the divisional IDT electrode 2504c and the lower electrode 2506a of the divisional IDT electrode 2504a.

Thus, even if a symmetric configuration is adopted for the above- described surface acoustic wave filter, the same effects can be obtained.

(Embodiment A3)

The surface acoustic wave filter according to Embodiment A3 of the present invention will be explained below with reference to the attached drawings. FIG. 8 is a schematic view of the surface acoustic wave filter according to Embodiment A3.

In FIG. 8, reference numeral 2601 denotes a piezoelectric substrate and it is possible to excite a surface acoustic wave by constructing electrode patterns crossing in strip-line form with a cyclic structure on this piezoelectric substrate 2601. A longitudinally coupled mode type surface acoustic wave filter comprising input IDT electrodes 2102a and 2102b, reflector electrodes 2103a and 2103b and an output IDT electrode 2104 is formed on the piezoelectric substrate 2601, and this embodiment in this configuration is the same as the surface acoustic wave filter shown in Embodiment A1.

In the above-described surface acoustic wave filter, the upper electrodes of the input IDT electrodes 2102a and 2102b are connected to an input terminal S via a surface acoustic wave resonator 2604 connected in series and formed of reflector electrodes 2602a, 2602b and an IDT electrode 2603. Furthermore, between the surface acoustic wave resonator 2604 and the upper electrodes of the input IDT electrodes 2102a and 2102b, a surface acoustic wave resonator 2607 formed of reflector electrodes 2605a and 2605b and an IDT electrode 2606 is connected in parallel and one end of the surface acoustic wave resonator 2607 is grounded.

FIG. 9 shows a passing characteristic of the above-described surface acoustic wave filter. FIG. 9a shows a configuration before the division, that is, a passing characteristic when the output IDT electrode 3004 of the conventional configuration shown in FIG . 12 is used instead of the output IDT electrode 2104 shown in Fig. 6. In FIG. 9a, the system is designed assuming that the number of pairs of output IDTs is 18 and output impedance is 50Ω. FIG. 9b of shows a characteristic assuming that the numbers of pairs of the first, second and third divisional IDT electrodes 2104a, 2104b. and 2104c are 6 respectively and output impedance is 100Ω. With regard to the passing characteristic in FIG. 9, FIG. 9a and FIG. 9b show the results of evaluation with 50Ω and 100Ω respectively as the condition of impedance on the output side. In FIG. 9b, the system is designed to have a total capacitance of the output IDT electrodes 1/2 and impedance of 100Ω twice those before the division. FIG. 9b shows that output impedance is changed while the waveform of the surface acoustic wave filter using the divisional IDT electrode maintains the passing characteristic almost equivalent to that before the division in FIG. 9a.

This embodiment places the surface acoustic wave resonator 2607 in series between the input IDT electrodes 2102a and 2102b and input terminal S and in parallel with the surface acoustic wave resonator 2604, but it is also possible to place a longitudinally coupledmode type surface acoustic wave filter as shown in FIG. 10 and form a surface acoustic wave filter in two-stage configuration.

In FIG. 10, reference numeral 2801 denotes a piezoelectric substrate, a first-stage surface acoustic wave filter 2802 is constructed of an input IDT electrode 2803, reflector electrodes 2804a and 2804b and output IDT electrodes 2805a and 2805b. The upper electrode of the input IDT electrode 2803 is connected to the input terminal S and the lower electrode is grounded. The upper electrode of the output IDT electrode 2805a is grounded and the lower electrode is connected to the input IDT electrode 2102a of a second-stage surface acoustic wave filter 2806. Furthermore, the upper electrode of the output IDT electrode 2805b is grounded and the lower electrode is connected to the input IDT electrode 2102b of the second-stage surface acoustic wave filter 2806. Here, the second-stage surface acoustic wave filter 2806 has the same configuration as that in FIG. A1 shown in Embodiment A1.

That is, the adjacent electrode fingers of the input IDT electrode 2803 and output IDT electrode 2805a of the first-stage surface acoustic wave filter 2802 are led out from the lower bus bar electrodes in the same direction and the adjacent electrode fingers of the input IDT electrode 2803 and output IDT electrode 2805c are led out from the lower bus bar electrodes in the same direction. In this case, same phase signals are transmitted from the output IDT electrodes 2805a and 2805b of the first-stage surface acoustic wave filter 2801 to the second-stage surface acoustic wave filter 2806.

Here, this embodiment assumes that the adj acent electrode fingers of the input IDT electrode 2803 and output IDT electrode 2805a of the first- stage surface acoustic wave filter 2802 are led out from the lower electrodes in the same direction and the adjacent electrode fingers of the input IDT electrode 2803 and output IDT electrode 2805b are led out from the lower bus bar electrodes in the same direction, but even if the adjacent electrode fingers of the input IDT electrode 2805 and output IDT electrode 2805a are led out from the respective electrodes in directions crossing each other and the adjacent electrode fingers of the input IDT electrode 2803 and output IDT electrode 2805b are led out from the respective electrodes in directions crossing each other, the same characteristic as the surface acoustic wave filter can be obtained likewise as far as the output IDT electrodes 2805a and 2805b are in such a phase relationship that surface acoustic waves do not cancel out each other.

This positional relationship varies depending on the number of electrode fingers, etc. and a positional relationship different from this positional relationship may also be used as far as it provides at least a phase relationship whereby surface acoustic waves are excited without canceling out each other.

Furthermore, this embodiment places the surface acoustic wave resonator 2607 in series between the input IDT electrodes 2102a and 2102b and input terminal S, and in parallel with the surface acoustic wave resonator 2604, but it is also possible to place a longitudinally coupled mode type surface acoustic wave filter as shown in FIG. 11 to form a surface acoustic wave filter in a two- stage configuration.

In FIG. 11, reference numeral 2901 denotes a piezoelectric substrate, a first-stage surface acoustic wave filter 2902 is constructed of an input IDT electrode 2903, reflector electrodes 2904a and 2904b and output IDT electrodes 2905a and 2905b. The upper electrode of the input IDT electrode 2903 is connected to the input terminal S and the lower electrode is grounded. The upper electrode of the output IDT electrode 2905a is grounded and the lower electrode is connected to the input IDT electrode 2502a of a second-stage surface acoustic wave filter 2906. Furthermore, the upper electrode of the output IDT electrode 2905b is grounded and the lower electrode is connected to the input IDT electrode 2502b of the second-stage surface acoustic wave filter 2906. Here, the second-stage surface acoustic wave filter 2906 has the same configuration as that in Embodiment A2.

Furthermore, the output IDT electrodes 2905a and 2905b of the first- stage surface acoustic wave filter 2902 are in a positional relationship having phases opposite each other. That is, reverse phase signals are transmitted from the output IDT electrodes 2905a and 2905b of the first- stage surface acoustic wave filter 2902 to the second- stage surface acoustic wave filter 2906.

The above-described configuration makes the signals from the output IDT electrodes 2905a and 2905b of the first-stage surface acoustic wave filter 2902 opposite each other, making it possible to suppress characteristic degradation due to spatial coupling in the route up to the second-stage surface acoustic wave filter and reduce balancing deterioration due to direct coupling between the input IDT electrodes 2502a and 2502b and the output IDT 2504 of the second-stage surface acoustic wave filter 2906.

By placinga surface acoustic wave filter using divisional IDT electrodes for both the first and second stages, this embodiment can control impedance on both the input side and output side.

Furthermore, the surface acoustic wave filter of the present invention can control impedance and using this surface acoustic wave filter for a mobile unit communication apparatus facilitates impedance matching of IC, etc. and makes it possible to realize a high performance communication apparatus.

Thus, this embodiment has an advantage of providing a longitudinally coupled mode type surface acoustic wave filter with balanced type terminals, capable of controlling input/ output impedance.

Furthermore, a communication apparatus using the surface acoustic wave filter of the present invention for a transmission circuit and/or reception circuit also belongs to the present invention.

(Embodiment A6)

A communication apparatus according to Embodiment A6 of the present invention will be explained below with reference to the attached drawings. FIG. A17 is a block diagram of communication apparatus 1001 using the surface acoustic wave filter or balanced type filter of the present invention. In FIG. A17, a transmission signal output from a transmission circuit is passed through a transmission amplifier 1002, a transmission filter 1003 and a switch 1004 and sent out from an antenna 1005. On the other hand, a reception signal received by antenna 1005 is passed through the switch 1004, a reception filter 1006 and a reception amplifier 1007 and input to a reception circuit.

Here, since the transmission amplifier 1002 is of a balanced type and the switch 1004 is of an unbalanced type, the transmission filter 1003 has a configuration having an unbalanced- balanced type terminal. Furthermore, since the reception amplifier 1007 is of a balanced type and the switch 1004 is of an unbalanced type, the reception filter 1006 has a configuration having an unbalanced- balanced type terminal.

Applying the surface acoustic wave filter or balanced type filter of this embodiment of the present invention to the transmission filter 1003 or reception filter 1006 of the communication apparatus 1001 can suppress deterioration in modulation accuracy during transmission due to deterioration of the balance characteristic and suppress deterioration in the sensitivity during reception due to deterioration of the balance characteristic, making it possible to realize a high performance communication apparatus.

By the way, Embodiment A6 has been described assuming that the transmission filter 1003 and reception filter 1006 are of an unbalanced - balanced type, but when the switch 1004 is of a balanced type, it is possible to provide balanced type transmission filter 1003 and balanced type reception filter 1006.

Furthermore, when the switch 1004 is of a balanced type and the transmission amplifier 1002 or reception amplifier 1007 is of an unbalanced type, it is possible to obtain similar effects by switching between the balanced type and unbalanced type input/ output terminals of the transmission filter 1003 or reception filter 1006.

Furthermore, this embodiment has described the case where the switch 1004 is used as the means for switching between transmission and reception at communication apparatus 1001, but a duplexer can be used instead.

The surface acoustic wave filter of this embodiment allows impedance matching without adding an inductance between the balanced type terminals as the matching circuit. Therefore, applying the surface acoustic wave filter of this embodiment to a mobile unit communication apparatus further makes it possible to reduce the size of the mobile unit communication apparatus.

Of the embodiments of the present invention, the embodiments of group A have been explained so far.

As to the piezoelectric substrate in the present invention, use of an ST cut crystal having excellent temperature characteristics is preferable, but there may be used as substrates $LiTaO_3$, $LiNbO_3$, $Li_2B_4O_7$, $La_3Ga_3SiO_{14}$ and the like. As an electrode material, use of relatively low density aluminum whose film thickness control is easy is preferable, but use of gold electrode is also possible.

Furthermore, the present invention is applicable to resonators using not only the SAW described above but also SSBW (Surface Skimming Balk Wave) which is one of the SAW or Pseudo surface waves, and the like.

As is apparent from the above-described explanations, the present invention can provide a surface acoustic wave filter and communication apparatus with optimal balancing and capable of controlling input/output impedance.

The present invention can also provide an inter-digital transducer, surface acoustic wave filter and communication apparatus having desired input/output impedance.

## Claims

**1.** A surface acoustic wave filter comprising:

a piezoelectric substrate (2101);
a plurality of inter-digital transducer electrodes, hereinafter called IDT electrodes, (2102a, 2102b, 2104) having a pair of upper bus bar electrode and lower bus bar electrode facing each other placed on said piezoelectric substrate and a plurality of electrode fingers each being led out from either said upper bus bar electrode or said lower bus bar electrode toward the other bus bar electrode;
a plurality of reflector electrodes (2103a, 2103b) placed on said piezoelectric substrate, and
a balanced type terminal (T1, T2) placed on said piezoelectric substrate,
said surface acoustic wave filter being a longitudinally coupled mode type surface acoustic wave filter in which said plurality of IDT electrodes and said plurality of reflector electrodes are placed in the propagation directions of surface acoustic waves respectively,
**characterized in that**
at least one of said plurality of IDT electrodes is constructed of three or more divisional IDT electrodes (2104a, 2104b, 2104c), and said divisional IDT electrodes are connected to said balanced type terminal, and
at least two of said divisional IDT electrodes (2104b, 2104c) are connected in series and at least one (2104a) of the remaining divisional IDT electrodes is connected in parallel with said at least two divisional IDT electrodes.

2. The surface acoustic wave filter according to claim 1, wherein the ratio in the number of electrode fingers among said plurality of divisional IDT electrodes (2104a, 2104b, 2104c) is adjusted beforehand so as to have a predetermined impedance value.

3. The surface acoustic wave filter according to claim 2, wherein said plurality of divisional IDT electrodes (2104a, 2104b, 2104c) is placed in a same/reverse phase relationship so that charges of the divisional IDT electrodes do not cancel out each other.

4. The surface acoustic wave filter according to claim 1,
wherein said second divisional IDT electrode (2104b) is placed in a same phase relationship between said first divisional IDT electrode (2104a) and said third divisional IDT electrode(2104c),
the part of said upper bus bar electrode corresponding to said first divisional IDT electrode and the part of said upper bus bar electrode corresponding to said second divisional IDT electrode are connected to one end (T1) of said balanced type terminal, and the part of said lower bus bar electrode corresponding to said second divisional IDT electrode and the part of said lower bus bar electrode corresponding to said third divisional IDT electrode are connected to the other end (T2) of said balanced type terminal, and
wherein the part of said lower bus bar electrode corresponding to said first divisional IDT electrode is connected to the part of said upper bus bar electrode corresponding to said third divisional IDT electrode.

5. The surface acoustic wave filter according to claim 1, wherein said second divisional IDT electrode (2104b) is placed between said first divisional IDT electrode (2104a) and said third divisional IDT electrode (2104c), the part of said lower bus bar electrode corresponding to said first divisional IDT electrode is connected to the part of said upper bus bar electrode corresponding to said second divisional IDT electrode, and the part of said lower bus bar electrode corresponding to said second divisional IDT electrode is connected to the part of said lower bus bar electrode corresponding to said third divisional IDT electrode, and
the upper bus bar electrode of said first divisional IDT electrode is connected to the lower bus bar electrode of said third divisional IDT electrode.

6. The surface acoustic wave filter according to claim 3, wherein said plurality of divisional IDT electrodes is constructed of first (2104b1), second (2104a), third (2104c) and fourth (2104b2) divisional IDT electrodes.

7. The surface acoustic wave filter according to claim 6,
wherein said plurality of divisional IDT electrodes is placed in order of said first (2104b1), second (2104a), third (2104c) and fourth (2104b2) divisional IDT electrodes,
the part of said upper bus bar electrode corresponding to said first divisional IDT electrode, the part of said upper bus bar electrode corresponding to said third divisional IDT electrode and the part of said upper bus bar electrode corresponding to said fourth divisional IDT electrode are connected in a same phase relationship, and
the part of said lower bus bar electrode corresponding to said first divisional IDT electrode, the part of said lower bus bar electrode corresponding to said second divisional IDT electrode and the part of said lower bus bar electrode corresponding to said fourth divisional IDT electrode are connected.

8. The surface acoustic wave filter according to claim 7,

wherein of said plurality of electrode fingers, substantially all adjacent pairs of electrode fingers are in a same phase relationship and substantially all of the plurality of electrode fingers is connected so that respective charges do not cancel out each other.

**9.** The surface acoustic wave filter according to claim 7,
wherein the part of said upper bus bar electrode corresponding to said second IDT electrode (2104a) is grounded and the part of said lower bus bar electrode corresponding to said third IDT electrode (2104c) is grounded.

**10.** The surface acoustic wave filter according to claim 7,
wherein the part of said upper bus bar electrode corresponding to said second IDT electrode (2104a) is connected to the part of said lower bus bar electrode corresponding to said third IDT electrode (2104c).

**11.** The surface acoustic wave filter according to claim 10,
wherein said "connection" means that, of adjacent electrode fingers of said second divisional IDT electrode (2104a) and said third divisional IDT electrode (2104c), said second divisional IDT electrode digit is connected to both the part of said upper electrode corresponding to said second divisional IDT electrode and the part of said lower electrode corresponding to said third divisional IDT electrode, and
of adjacent electrode fingers said third divisional IDT electrode digit is connected to both the part of said lower electrode corresponding to said third divisional IDT electrode (2104c) and the part of said upper electrode corresponding to said second divisional IDT electrode (2104a).

**12.** The surface acoustic wave filter according to claim 1,
wherein said three IDT electrodes are first, second and third IDT electrodes,
said second IDT electrode (2102a) and said third IDT electrode (2102b) are placed on both sides of said first IDT electrode (2104) respectively,
said reflector electrodes (2103a, (2103b) are placed opposite said first IDT electrode of said second IDT electrode and opposite said first IDT electrode of said third IDT electrode respectively, and
said first IDT electrode is the IDT electrode of said inter-digital transducer.

**13.** The surface acoustic wave filter according to claim 12, wherein the upper bus bar electrode of said second IDT electrode (2102a) is connected to an unbalanced type terminal (S) and the lower bus bar electrode is grounded and the lower bus bar electrode (2102b) of said third IDT electrode is connected to said unbalanced type terminal and the upper bus bar electrode is grounded.

**14.** A surface acoustic wave filter comprising:

a piezoelectric substrate (2101);
a plurality of longitudinally coupled mode type surface acoustic wave filters having a plurality of IDT electrodes (2102a, 2102b, 2104) and a plurality of reflector electrodes (2103a, 2103b) placed on said piezoelectric substrate,
wherein said plurality of surface acoustic wave filters are connected in multiple stages,
of said plurality of surface acoustic wave filters, at least the surface acoustic wave filters on the input side and/or the surface acoustic wave filters on the output side are the surface acoustic wave filters according to claim 1, and said piezoelectric substrates of at least the surface acoustic wave filters on the input side and/or the surface acoustic wave filters on the output side of said plurality of surface acoustic wave filters are the piezoelectric substrates of the surface acoustic wave filters according to claim 1.

**15.** The surface acoustic wave filter according to claim 14,
wherein said plurality means 2,
said plurality of acoustic wave filters area first surface acoustic wave filter and a second surface acoustic wave filter,
said first and second surface acoustic wave filters each comprise at least three IDT electrodes (2102a, 2102b, 2104).
said first and second surface acoustic wave filters are connected in cascade form,
said first and second surface acoustic wave filters are connected at two points using at least two IDT electrodes, and the phase of one signal of said IDT electrode is opposite the phase of the other signal of said IDT electrode.

**16.** A surface acoustic wave filter according to claim 1, whereby the number of IDT transducer electrode is equal to two, and whereby,
the part of said upper bus bar electrode of said IDT electrode corresponding to said first divisional IDT electrode (2104a) and/or the part of said upper bus bar electrode of said IDT electrode corresponding to said second divisional IDT electrode (2104b) are connected to one end (T1) of said balanced type terminal, and
the part of said lower bus bar electrode of said IDT electrode corresponding to said second divisional IDT electrode (2104b) and/or the part of said lower bus bar electrode of said IDT electrode corresponding to said third divisional IDT electrode (2104c) are connected to the other end (T2) of said balanced type terminal.

**17.** A surface acoustic wave filter according to claim 1 whereby the number of
IDT transducer electrodes is equal to five, and whereby
the part of said upper bus bar electrode of said IDT electrode corresponding to said first divisional IDT electrode (2104a) and/or the part of said upper bus bar electrode of said IDT electrode corresponding to said second divisional IDT electrode (2104b) are connected to one end (T1) of a balanced type terminal, and
the part of said lower bus bar electrode of said IDT electrode corresponding to said second divisional IDT electrode (2104b) and/or the part of said lower bus bar electrode of said IDT electrode corresponding to said third divisional IDT electrode (2104c) are connected to the other end (T2) of said balanced type terminal.

**18.** A communication apparatus comprising:

a transmission circuit that outputs transmission waves; and
a reception circuit that receives reception waves,
wherein the surface acoustic wave filter used for said transmission circuit and/or said reception circuit is the surface acoustic wave filter according to claim 1.

## Patentansprüche

**1.** Akustisches Oberflächenwellenfilter, umfassend:

ein piezoelektrisches Substrat (2101);
eine Vielzahl interdigitaler Wandlerelektroden, im folgenden IDT-Elektroden genannt (2102a, 2102b, 2104), die ein Paar bestehend aus einer oberen Sammelschienenelektrode und einer unteren Sammelschienenelektrode haben, die einander zugewandt auf dem piezoelektrischen Substrat angeordnet sind, sowie eine Vielzahl von Elektrodenfingern, die entweder aus der oberen Sammelschienenelektrode oder der unteren Sammelschienenelektrode zu der anderen Sammelschienenelektrode geleitet sind;
eine Vielzahl Reflektorelektroden (2103a, 2103b), die auf dem piezoelektrischen Substrat angeordnet sind, und einen symmetrischen Anschluss (T1, T2), der auf dem piezoelektrischen Substrat angeordnet ist,
wobei das akustische Oberflächenwellenfilter ein akustisches Oberflächenwellenfilter vom Typ eines in Längsrichtung gekoppelten Modus' ist, bei dem die Vielzahl von IDT-Elektroden und die Vielzahl von Reflektorelektroden jeweils in den Ausbreitungsrichtungen akustischer Oberflächenwellen angeordnet sind,
**dadurch gekennzeichnet, dass**
wenigstens eine aus der Vielzahl von IDT-Elektroden aus wenigstens drei Teil-IDT-Elektroden (2104a, 2104b, 2104c) aufgebaut ist und diese Teil-IDT-Elektroden mit dem symmetrischen Anschluss verbunden sind und wenigstens zwei der Teil-IDT-Elektroden (2104b, 2104c) in Reihe geschaltet sind und wenigstens eine (2104a) der verbleibenden Teil-IDT-Elektroden mit den wenigstens zwei Teil-IDT-Elektroden parallel geschaltet ist.

**2.** Akustisches Oberflächenwellenfilter nach Anspruch 1, bei dem das Verhältnis der Zahl der Elektrodenfinger innerhalb der Vielzahl von Teil-IDT-Elektroden (2104a, 2104b, 2104c) im Voraus eingestellt ist, um so einen vorbestimmten Impedanzwert zu haben.

**3.** Akustisches Oberflächenwellenfilter nach Anspruch 2, bei dem die Vielzahl von Teil-IDT-Elektroden (2104a, 2104b, 2104c) in einer gleichphasigen/gegenphasigen Beziehung angeordnet ist, so dass sich Ladungen der Teil-IDT-Elektroden nicht gegenseitig aufheben.

**4.** Akustisches Oberflächenwellenfilter nach Anspruch 1,
bei dem die zweite Teil-IDT-Elektrode (2104b) in einer gleichphasigen Beziehung zwischen der ersten Teil-IDT-Elektrode (2104a) und der dritten Teil-IDT-Elektrode (2104c) angeordnet ist,
der Teil der oberen Sammelschienenelektrode, der der ersten Teil-IDT-Elektrode entspricht, und der Teil der oberen Sammelschienenelektrode, der der zweiten Teil-IDT-Elektrode entspricht, mit einem Ende (T1) des symmetrischen Anschlusses verbunden sind und der Teil der unteren Sammelschienenelektrode, der der zweiten Teil-IDT-Elektrode entspricht, sowie der Teil der unteren Sammelschienenelektrode, der der dritten Teil-IDT-Elektrode entspricht, mit dem anderen Ende (T2) des symmetrischen Anschlusses verbunden sind und
der Teil der unteren Sammelschienenelektrode, der der ersten Teil-IDT-Elektrode entspricht, mit dem Teil der oberen Sammelschienenelektrode verbunden ist, der der dritten Teil-IDT-Elektrode entspricht.

**5.** Akustisches Oberflächenwellenfilter nach Anspruch 1, bei dem die zweite Teil-IDT-Elektrode (2104b) zwischen der ersten Teil-IDT-Elektrode (2104a) und der dritten Teil-IDT-Elektrode (2104c) angeordnet ist, der Teil der unteren Sammelschienenelektrode, der der ersten Teil-IDT-Elektrode entspricht, mit dem Teil der oberen Sammelschienenelektrode verbunden ist, der der zweiten Teil-IDT-Elektrode entspricht, und der Teil der unteren Sammelschienenelektrode, der der zweiten Teil-IDT-Elektrode entspricht, mit dem Teil der unteren Sammelschienenelektrode verbunden ist, der der dritten Teil-IDT-Elektrode entspricht und
die obere Sammelschienenelektrode der ersten Teil-IDT-Elektrode mit der unteren Sammelschienenelektrode der dritten Teil-IDT-Elektrode verbunden ist.

**6.** Akustisches Oberflächenwellenfilter nach Anspruch 3, bei dem die Vielzahl von Teil-IDT-Elektroden aus ersten (2104b1), zweiten (2104a), dritten (2104c) und vierten (2104b2) Teil-IDT-Elektroden aufgebaut ist.

**7.** Akustisches Oberflächenwellenfilter nach Anspruch 6,
bei dem die Vielzahl von Teil-IDT-Elektroden in der Reihenfolge von erster (2104b1), zweiter (2104a), dritter (2104c) und vierter (2104b2) Teil-IDT-Elektroden angeordnet ist,
der Teil der oberen Sammelschienenelektrode, der der ersten Teil-IDT-Elektrode entspricht, der Teil der oberen Sammelschienenelektrode, der der dritten Teil-IDT-Elektrode entspricht, und der Teil der oberen Sammelschienenelektrode, der der vierten Teil-IDT-Elektrode entspricht, in gleichphasiger Beziehung verbunden sind, und
der Teil der unteren Sammelschienenelektrode, der der ersten Teil-IDT-Elektrode entspricht, der Teil der unteren Sammelschienenelektrode, der der zweiten Teil-IDT-Elektrode entspricht, und der Teil der unteren Sammelschienenelektrode, der der vierten Teil-IDT-Elektrode entspricht, miteinander verbunden sind.

**8.** Akustisches Oberflächenwellenfilter nach Anspruch 7,
bei dem aus der Vielzahl von Elektrodenfingern im wesentlichen sämtliche benachbarten Paare von Elektrodenfingern in phasengleicher Beziehung sind und im wesentlichen sämtliche der Vielzahl von Elektrodenfingern derart verbunden sind, dass sich entsprechende Ladungen nicht gegenseitig aufheben.

**9.** Akustisches Oberflächenwellenfilter nach Anspruch 7,
bei dem der Teil der oberen Sammelschienenelektrode, der der zweiten IDT-Elektrode (2104a) entspricht, geerdet ist und der Teil der unteren Sammelschienenelektrode, der der dritten IDT-Elektrode (2104c) entspricht, geerdet ist.

**10.** Akustisches Oberflächenwellenfilter nach Anspruch 7,
bei dem der Teil der oberen Sammelschienenelektrode, der der zweiten IDT-Elektrode (2104a) entspricht, mit dem Teil der unteren Sammelschienenelektrode verbunden ist, der der dritten IDT-Elektrode (2104c) entspricht.

**11.** Akustisches Oberflächenwellenfilter nach Anspruch 10,
bei dem "Verbindung" bedeutet, dass von benachbarten Elektrodenfingern der zweiten Teil-IDT-Elektrode (2104a) und der dritten Teil-IDT-Elektrode (2104c) der zweite Teil-IDT-Elektrodenfinger sowohl mit dem Teil der oberen Elektrode, der der zweiten Teil-IDT-Elektrode entspricht, als auch mit dem Teil der unteren Elektrode verbunden ist, der der dritten Teil-IDT-Elektrode entspricht, und
von benachbarten Elektrodenfingern der dritte Teil-IDT-Elektrodenfinger sowohl mit dem Teil der unteren Elektrode, der der dritten Teil-IDT-Elektrode (2104c) entspricht, als auch mit dem Teil der oberen Elektrode verbunden ist, der der zweiten Teil-IDT-Elektrode (2104a) entspricht.

**12.** Akustisches Oberflächenwellenfilter nach Anspruch 1,
bei dem die drei IDT-Elektroden erste, zweite und dritte IDT-Elektroden sind,
die zweite IDT-Elektrode (2102a) und die dritte IDT-Elektrode (2102b) jeweils auf beiden Seiten der ersten IDT-Elektrode (2104) angeordnet sind,
die Reflektorelektroden (2103a), (2103b) gegenüber der ersten IDT-Elektrode der zweiten IDT-Elektrode bzw. gegenüber der ersten IDT-Elektrode der dritten IDT-Elektrode angeordnet sind und
die erste IDT-Elektrode die IDT-Elektrode des interdigitalen Wandlers ist.

**13.** Akustisches Oberflächenwellenfilter nach Anspruch 12, bei dem die obere Sammelschienenelektrode der zweiten IDT-Elektrode (2102a) mit einem asymmetrischen Anschluss (S) verbunden ist, die untere Sammelschienenelektrode geerdet ist, die untere Sammelschienenelektrode (2102b) der dritten IDT-Elektrode mit dem asymmetrischen Anschluss verbunden ist und die obere Sammelschienenelektrode geerdet ist.

**14.** Akustisches Oberflächenwellenfilter umfassend:

ein piezoelektrisches Substrat (2101) und
eine Vielzahl akustischer Oberflächenwellenfilter vom Typ eines in Längsrichtung gekoppelten Modus', die eine Vielzahl von IDT-Elektroden (2102a, 2102b, 2104) und eine Vielzahl von Reflektorelektroden (2103a, 2103b) haben, die auf dem piezoelektrischen Substrat angeordnet sind,
wobei die Vielzahl von akustischen Oberflächenwellenfiltern in mehreren Stufen verbunden sind,
von der Vielzahl akustischer Oberflächenwellenfilter wenigstens die akustischen Oberflächenwellenfilter auf der Eingangsseite und/oder die akustischen Oberflächenwellenfilter auf der Ausgangsseite die akustischen Oberflächenwellenfilter nach Anspruch 1 sind, und
die piezoelektrischen Substrate wenigstens der akustischen Oberflächenwellenfilter auf der Eingangsseite und/oder der akustischen Oberflächenwellenfilter auf der Ausgangseite aus der Vielzahl von akustischen Oberflächenwellenfiltern die piezoelektrischen Substrate der akustischen Oberflächenwellenfilter nach Anspruch 1 sind.

**15.** Akustisches Oberflächenwellenfilter nach Anspruch 14,
bei dem die Vielzahl 2 bedeutet,
die Vielzahl akustischer Oberflächenwellenfilter ein erstes akustisches Oberflächenwellenfilter und ein zweites akustisches Oberflächenwellenfilter sind,
die ersten und zweiten akustischen Oberflächenwellenfilter jeweils wenigstens drei IDT-Elektroden (2102a, 2102b, 2104) umfassen,
die ersten und zweiten akustischen Oberflächenwellenfilter kaskadenartig verbunden sind,
die ersten und zweiten akustischen Oberflächenwellenfilter an zwei Punkten mit Hilfe wenigstens zweier IDT-Elektroden verbunden sind und
die Phase eines Signals der IDT-Elektrode der Phase des anderen Signals der IDT-Elektrode entgegengesetzt ist.

**16.** Akustisches Oberflächenwellenfilter nach Anspruch 1, bei dem die Zahl von IDT-Elektroden gleich zwei ist und
der Teil der oberen Sammelschienenelektrode der IDT-Elektrode, der der ersten Teil-IDT-Elektrode (2104a) entspricht und/oder der Teil der oberen Sammelschienenelektrode der IDT-Elektrode, der der zweiten Teil-IDT-Elektrode (2104b) entspricht, mit dem einem Ende (T1) des symmetrischen Anschlusses verbunden ist/sind und
der Teil der unteren Sammelschienenelektrode der IDT-Elektrode, der der zweiten Teil-IDT-Elektrode (2104b) entspricht, und/oder der Teil der unteren Sammelschienenelektrode der IDT-Elektrode, der der dritten Teil-IDT-Elektrode (2104c) entspricht, mit dem anderen Ende T2 des symmetrischen Anschlusses verbunden ist/sind.

**17.** Akustisches Oberflächenwellenfilter nach Anspruch 1, bei dem die Zahl von IDT-Elektroden gleich fünf ist und
der Teil der oberen Sammelschienenelektrode der IDT-Elektrode, der der ersten Teil-IDT-Elektrode (2104a) entspricht und/oder der Teil der oberen Sammelschienenelektrode der IDT-Elektrode, der der zweiten Teil-IDT-Elektrode (2104b) entspricht, mit dem einen Ende (T1) eines symmetrischen Anschlusses verbunden ist/sind und
der Teil der unteren Sammelschienenelektrode der IDT-Elektrode, der der zweiten Teil-IDT-Elektrode (2104b) entspricht, und/oder der Teil der unteren Sammelschienenelektrode der IDT-Elektrode, der der dritten Teil-IDT-Elektrode (2104c) entspricht, mit dem anderen Ende (T2) des symmetrischen Anschlusses verbunden ist/sind.

**18.** Kommunikationsgerät, umfassend:

einen Sendeschaltkreis, der Sendewellen ausgibt, und
einen Empfangsschaltkreis, der Empfangswellen empfängt,
wobei das akustische Oberflächenwellenfilter, das für den Sendeschaltkreis und/oder den Empfangsschaltkreis verwendet wird, das akustische Oberflächenwellenfilter nach Anspruch 1 ist.

## Revendications

**1.** Filtre d'onde acoustique de surface, comprenant :

un substrat piézoélectrique (2101) ;
une pluralité d'électrodes à transducteur interdigital IDT, soit Inter-Digital Transducer, appelées ci-après électrodes IDT (2102a, 2102b, 2104), comportant une paire d'électrodes constituée d'une électrode de barre de bus supérieure et d'une électrode de barre de bus inférieure se faisant face et placées sur ledit substrat piézoélectrique, et une pluralité de doigts d'électrode chacun menés soit depuis ladite électrode de barre de bus supérieure, soit depuis ladite électrode de barre de bus inférieure vers l'autre électrode de barre de bus ;
une pluralité d'électrodes de réflecteur (2103a, 2103b) placées sur ledit substrat piézoélectrique, et
une borne de type équilibré (T1, T2) placée sur ledit substrat piézoélectrique,
ledit filtre d'onde acoustique de surface étant un filtre d'onde acoustique de surface du type mode à accouplement longitudinal dans lequel ladite pluralité d'électrodes IDT et ladite pluralité d'électrodes de réflecteur sont respectivement placées dans les directions de propagation d'ondes acoustiques de surface,
**caractérisé en ce que**
au moins une électrode de ladite pluralité d'électrodes IDT est constituée d'au moins trois électrodes IDT divisionnaires (2104a, 2104b, 2104c), et lesdites électrodes IDT divisionnaires sont connectées à ladite borne de type équilibré, et
au moins deux desdites électrodes IDT divisionnaires (2104b, 2104c) sont connectées en série et au moins une (2104a) des électrodes IDT divisionnaires restantes sont connectées en parallèle avec lesdites au moins deux électrodes IDT divisionnaires.

2. Filtre d'onde acoustique de surface selon la revendication 1, dans lequel le ratio du nombre de doigts d'électrode parmi ladite pluralité d'électrodes IDT divisionnaires (2104a, 2104b, 2104c) est ajusté à l'avance de manière à avoir une valeur d'impédance prédéterminée.

3. Filtre d'onde acoustique de surface selon la revendication 2, dans lequel ladite pluralité d'électrodes IDT divisionnaires (2104a, 2104b, 2104c) est placée dans une relation de phase identique/inverse de telle sorte que les charges des électrodes IDT divisionnaires ne s'annulent pas entre elles.

4. Filtre d'onde acoustique de surface selon la revendication 1,
dans lequel ladite deuxième électrode IDT divisionnaire (2104b) est placée dans une relation de phase identique entre ladite première électrode IDT divisionnaire (2104a) et ladite troisième électrode IDT divisionnaire (2104c),
la partie de ladite électrode de barre de bus supérieure correspondant à ladite première électrode IDT divisionnaire et la partie de ladite électrode de barre de bus supérieure correspondant à ladite deuxième électrode IDT divisionnaire sont connectées à une extrémité (T1) de ladite borne de type équilibré, et la partie de ladite électrode de barre de bus inférieure correspondant à ladite deuxième électrode IDT divisionnaire et la partie de ladite électrode de barre de bus inférieure correspondant à ladite troisième électrode IDT divisionnaire sont connectées à l'autre extrémité (T2) de ladite borne de type équilibré, et
dans lequel la partie de ladite électrode de barre de bus inférieure correspondant à ladite première électrode IDT divisionnaire est connectée à la partie de ladite électrode de barre de bus supérieure correspondant à ladite troisième électrode IDT divisionnaire.

5. Filtre d'onde acoustique de surface selon la revendication 1, dans lequel ladite deuxième électrode IDT divisionnaire (2104b) est placée entre ladite première électrode IDT divisionnaire (2104a) et ladite troisième électrode IDT divisionnaire (2104c), la partie de ladite électrode de barre de bus inférieure correspondant à ladite première électrode IDT divisionnaire est connectée à la partie de ladite électrode de barre de bus supérieure correspondant à ladite deuxième électrode IDT divisionnaire, et la partie de ladite électrode de barre de bus inférieure correspondant à ladite deuxième électrode IDT divisionnaire est connectée à la partie de ladite électrode de barre de bus inférieure correspondant à ladite troisième électrode IDT divisionnaire, et
l'électrode de barre de bus supérieure de ladite première électrode IDT divisionnaire est connectée à l'électrode de barre de bus inférieure de ladite troisième électrode IDT divisionnaire.

6. Filtre d'onde acoustique de surface selon la revendication 3, dans lequel ladite pluralité d'électrodes IDT divisionnaires est constituée par des première (2104b1), deuxième (2104a), troisième (2104c) et quatrième (2104b2) électrodes IDT divisionnaires.

7. Filtre d'onde acoustique de surface selon la revendication 6,
dans lequel ladite pluralité d'électrodes IDT divisionnaires est agencée selon l'ordre desdites première (2104b1), deuxième (2104a), troisième (2104c) et quatrième (2104b2) électrodes IDT divisionnaires,
la partie de ladite électrode de barre de bus supérieure correspondant à ladite première électrode IDT divisionnaire,
la partie de ladite électrode de barre de bus supérieure correspondant à ladite troisième électrode IDT divisionnaire,
et la partie de ladite électrode de barre de bus supérieure correspondant à ladite quatrième électrode IDT divisionnaire sont connectées selon une même relation de phase, et
la partie de ladite électrode de barre de bus inférieure correspondant à ladite première électrode IDT divisionnaire, la partie de ladite électrode de barre de bus inférieure correspondant à ladite deuxième électrode IDT divisionnaire, et la partie de ladite électrodede barre de bus inférieure correspondant à ladite quatrième électrode IDT divisionnaire sont connectées.

**8.** Filtre d'onde acoustique de surface selon la revendication 7,
dans lequel, parmi ladite pluralité de doigts d'électrode, pratiquement toutes les paires de doigts d'électrode adjacentes se trouvent dans une même relation de phase, et pratiquement tous les doigts de la pluralité de doigts d'électrode sont connectés de telle sorte que leurs charges respectives ne s'annulent pas entre elles.

**9.** Filtre d'onde acoustique de surface selon la revendication 7,
dans lequel la partie de ladite électrode de barre de bus supérieure correspondant à ladite deuxième électrode IDT divisionnaire (2104a) est mise à la terre, et la partie de ladite électrode de barre de bus inférieure correspondant à ladite troisième électrode IDT divisionnaire (2104c) est mise à la terre.

**10.** Filtre d'onde acoustique de surface selon la revendication 7,
dans lequel la partie de ladite électrode de barre de bus supérieure correspondant à ladite deuxième électrode IDT divisionnaire (2104a) est connectée à la partie de ladite électrode de barre de bus inférieure correspondant à ladite troisième électrode IDT divisionnaire (2104c).

**11.** Filtre d'onde acoustique de surface selon la revendication 10,
dans lequel ledit terme « connexion » signifie que, parmi les doigts d'électrode adjacents de ladite deuxième électrode IDT divisionnaire (2104a) et ladite troisième électrode IDT divisionnaire (2104c), ledit deuxième doigt d'électrode IDT divisionnaire est connecté aussi bien à la partie de ladite électrode supérieure correspondant à ladite deuxième électrode IDT divisionnaire qu'à la partie de ladite électrode inférieure correspondant à ladite troisième électrode IDT divisionnaire, et
parmi les doigts d'électrode adjacents, ledit troisième doigt d'électrode IDT divisionnaire est connecté aussi bien à la partie de ladite électrode inférieure correspondant à ladite troisième électrode IDT divisionnaire (2104c) qu'à la partie de ladite électrode supérieure correspondant à ladite deuxième électrode IDT divisionnaire (2104a).

**12.** Filtre d'onde acoustique de surface selon la revendication 1,
dans lequel lesdites trois électrodes IDT sont des première, deuxième et troisième électrodes IDT,
ladite deuxième électrode IDT (2102a) et ladite troisième électrode IDT (2102b) sont respectivement placées des deux côtés de ladite première électrode IDT (2104),
lesdites électrodes de réflecteur (2103a, 2103b) sont placées respectivement à l'opposé de ladite première électrode IDT par rapport à ladite deuxième électrode IDT et à l'opposé de ladite première électrode IDT par rapport à ladite troisième électrode IDT, et
ladite première électrode IDT est l'électrode IDT dudit transducteur interdigital.

**13.** Filtre d'onde acoustique de surface selon la revendication 12, dans lequel l'électrode de barre de bus supérieure de ladite deuxième électrode IDT (2102a) est connectée à une borne de type déséquilibré (S) et l'électrode de barre de bus inférieure est mise à la terre, et l'électrode de barre de bus inférieure (2102b) de ladite troisième électrode IDT est connectée à ladite borne de type déséquilibré et l'électrode de barre de bus supérieure est mise à la terre.

**14.** Filtre d'onde acoustique de surface, comprenant :

un substrat piézoélectrique (2101) ;
une pluralité de filtres d'onde acoustique de surface du type mode à accouplement longitudinal comportant une pluralité d'électrodes IDT (2102a, 2102b, 2104) et une pluralité d'électrodes de réflecteur (2103a, 2103b) placées sur ledit substrat piézoélectrique,
dans lequel les filtres de ladite pluralité de filtres d'onde acoustique de surface sont connectés par étages multiples,
parmi ladite pluralité de filtres d'onde acoustique de surface, au moins les filtres d'onde acoustique de surface du côté d'entrée et/ou les filtres d'onde acoustique de surface du côté de sortie sont des filtres d'onde acoustique de surface selon la revendication 1, et
lesdits substrats piézoélectriques au moins des filtres d'onde acoustique de surface sur le côté d'entrée et/ou des filtres d'onde acoustique de surface sur le côté de sortie de ladite pluralité de filtres d'onde acoustique de surface sont les substrats piézoélectriques des filtres d'onde acoustique de surface selon la revendication 1.

**15.** Filtre d'onde acoustique de surface selon la revendication 14,
dans lequel ladite pluralité est constituée de 2 éléments,
ladite pluralité de filtres d'onde acoustique est constituée d'un premier filtre d'onde acoustique de surface et d'un deuxième filtre d'onde acoustique de surface,
lesdits premier et deuxième filtres d'onde acoustique de surface comprennent chacun au moins trois électrodes IDT (2102a, 2102b, 2104),
lesdits premier et deuxième filtres d'onde acoustique de surface sont connectés en cascade,
lesdits premier et deuxième filtres d'onde acoustique de surface sont connectés en deux points en utilisant au moins deux électrodes IDT, et
la phase d'un signal de ladite électrode IDT est opposée à la phase de l'autre signal de ladite électrode IDT.

**16.** Filtre d'onde acoustique de surface selon la revendication 1, dans lequel le nombre d'électrodes de transducteur IDT est égal à deux, et dans lequel
la partie de ladite électrode de barre de bus supérieure de ladite électrode IDT correspondant à ladite première électrode IDT divisionnaire (2104a) et/ou la partie de ladite électrode de barre de bus supérieure de ladite électrode IDT correspondant à ladite deuxième électrode IDT divisionnaire (2104b) sont connectées à une extrémité (T1) de ladite borne de type équilibré, et
la partie de ladite électrode de barre de bus inférieure de ladite électrode IDT correspondant à ladite deuxième électrode IDT divisionnaire (2104b) et/ou la partie de ladite électrode de barre de bus inférieure de ladite électrode IDT correspondant à ladite troisième électrode IDT divisionnaire (2104c) sont connectées à l'autre extrémité (T2) de ladite borne de type équilibré.

**17.** Filtre d'onde acoustique de surface selon la revendication 1, dans lequel le nombre d'électrodes de transducteur IDT est égal à cinq, et dans lequel
la partie de ladite électrode de barre de bus supérieure de ladite électrode IDT correspondant à ladite première électrode IDT divisionnaire (2104a) et/ou la partie de ladite électrode de barre de bus supérieure de ladite électrode IDT correspondant à ladite deuxième électrode IDT divisionnaire (2104b) sont connectées à une extrémité (T1) d'une borne de type équilibré, et
la partie de ladite électrode de barre de bus inférieure de ladite électrode IDT correspondant à ladite deuxième électrode IDT divisionnaire (2104b) et/ou la partie de ladite électrode de barre de bus inférieure de ladite électrode IDT correspondant à ladite troisième électrode IDT divisionnaire (2104c) sont connectées à l'autre extrémité (T2) de ladite borne de type équilibré.

**18.** Appareil de communication comprenant :

un circuit de transmission qui sort des ondes de transmission, et
un circuit de réception qui reçoit des ondes de réception,
dans lequel le filtre d'onde acoustique de surface utilisé pour ledit circuit de transmission et/ou ledit circuit de réception est le filtre d'onde acoustique de surface selon la revendication 1.

Fig. 1

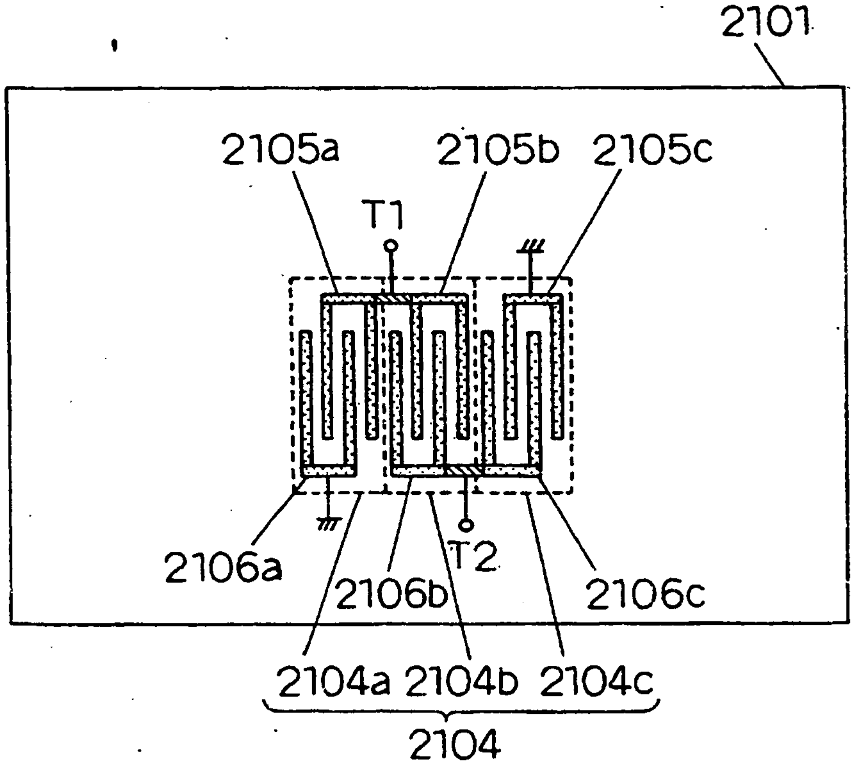
2101
2105a
2105b
2105c
T1
T2
2106a
2106b
2106c
2104a
2104b
2104c
2104

Fig. 2

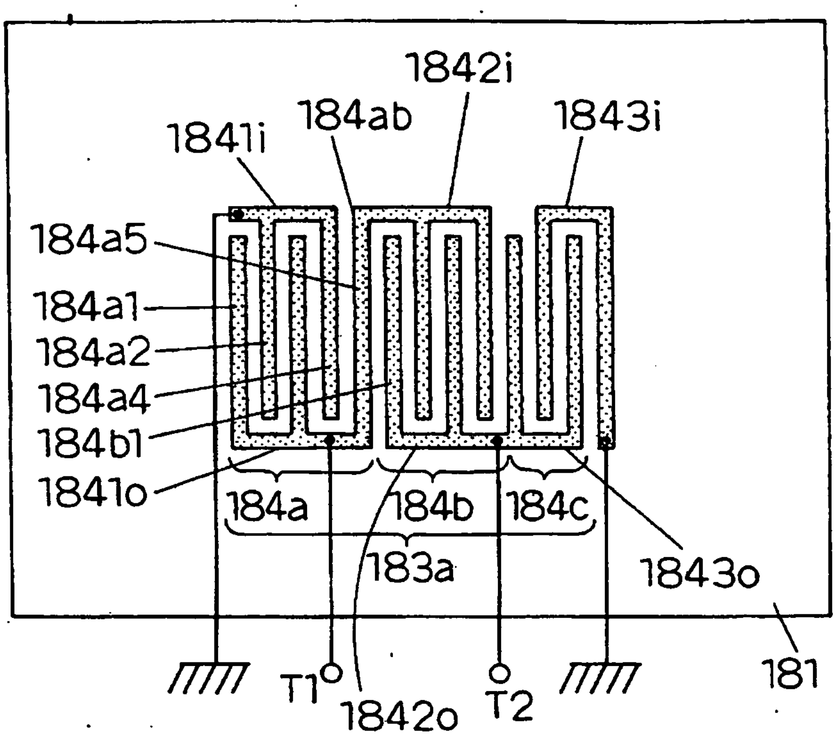
1842i
184ab
1843i
1841i
184a5
184a1
184a2
184a4
184b1
1841o
184a
184b
184c
183a
1843o
181
T1
1842o
T2

Fig. 3

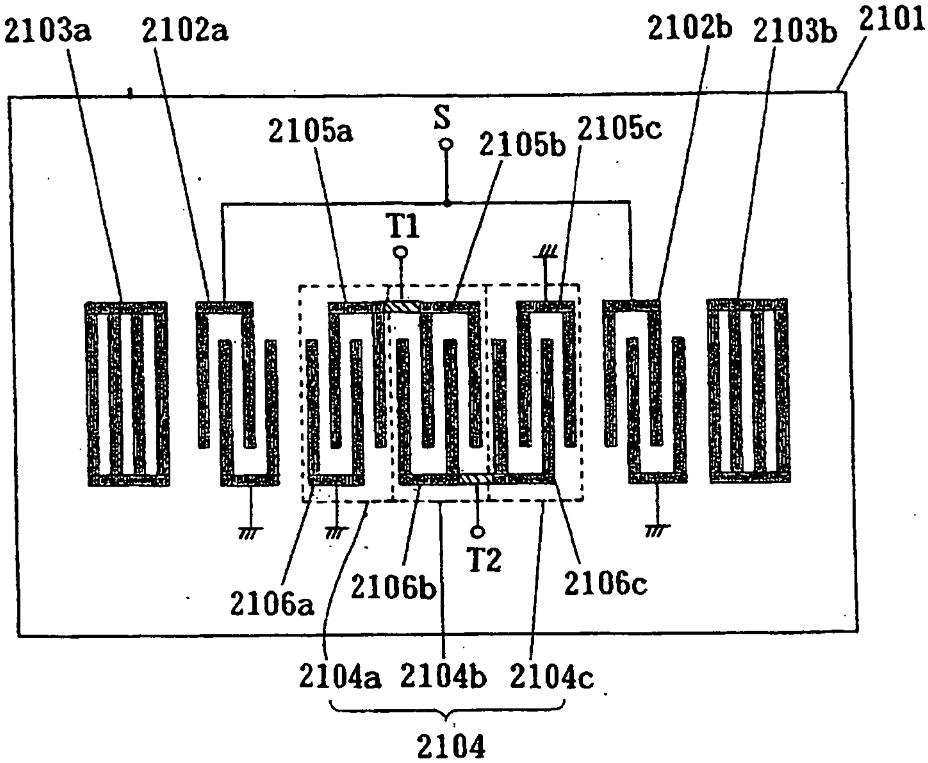
2103a
2102a
2102b
2103b
2101
2105a
S
2105b
2105c
T1
T2
2106a
2106b
2106c
2104a
2104b
2104c
2104

Fig. 4

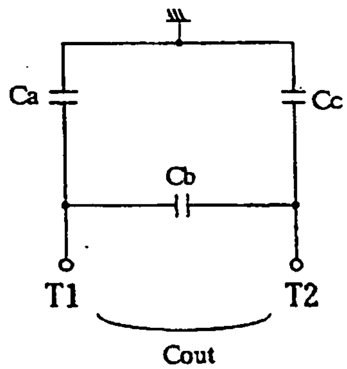

Fig. 5

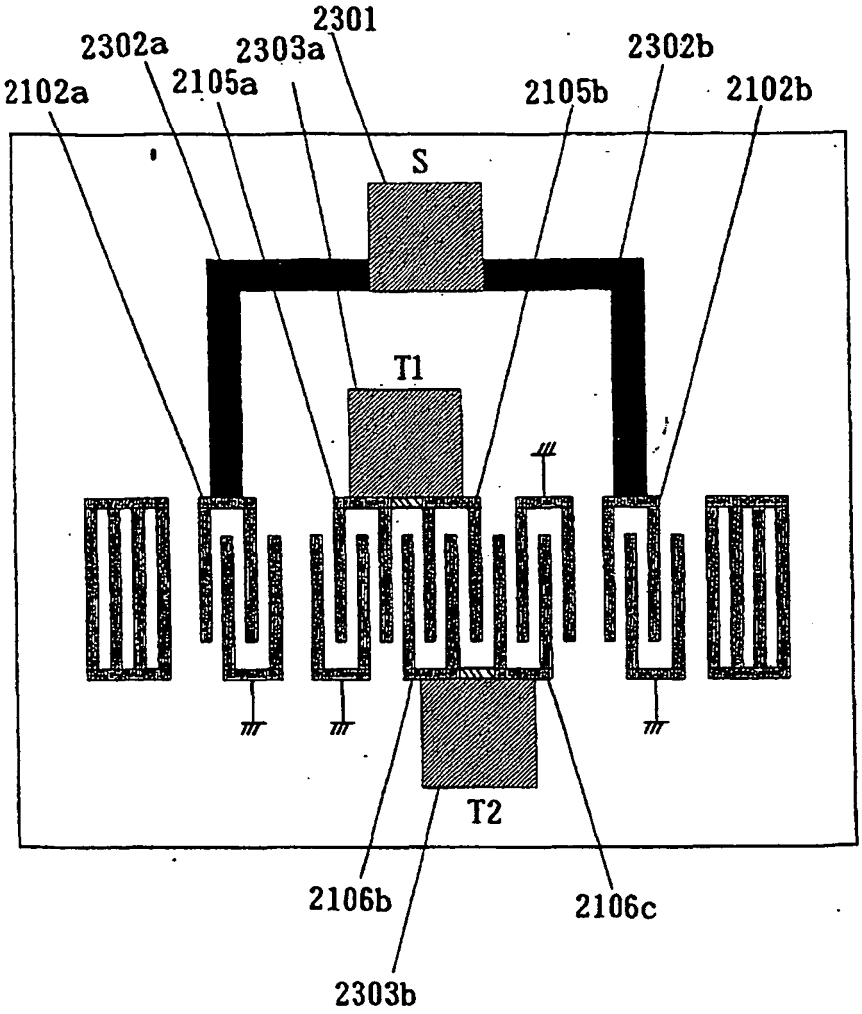
2301
2302a
2303a
2302b
2102a
2105a
2105b
2102b
S
T1
T2
2106b
2106c
2303b

Fig. 6

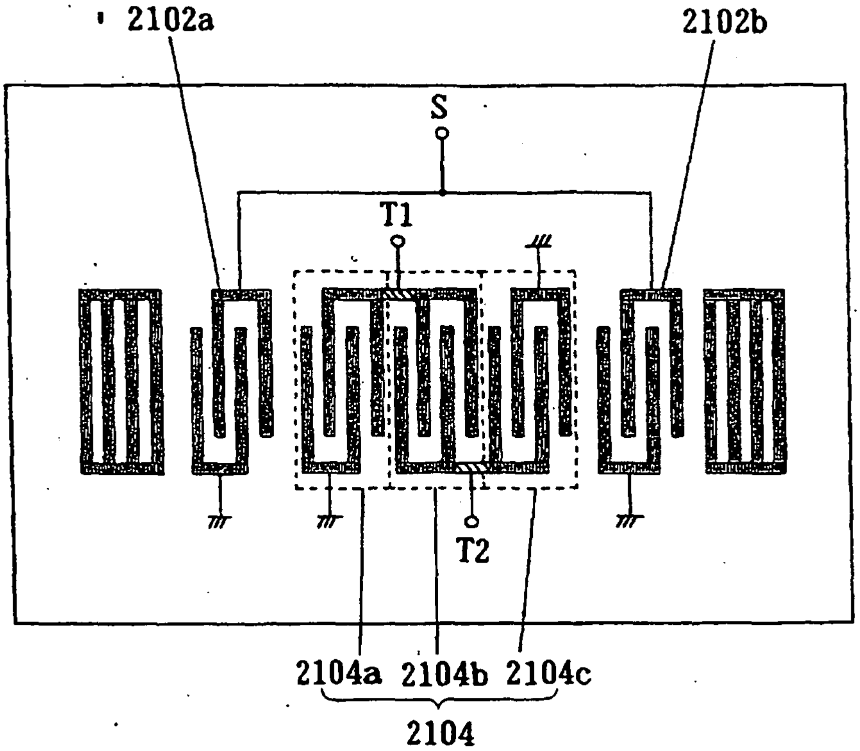

Fig. 7

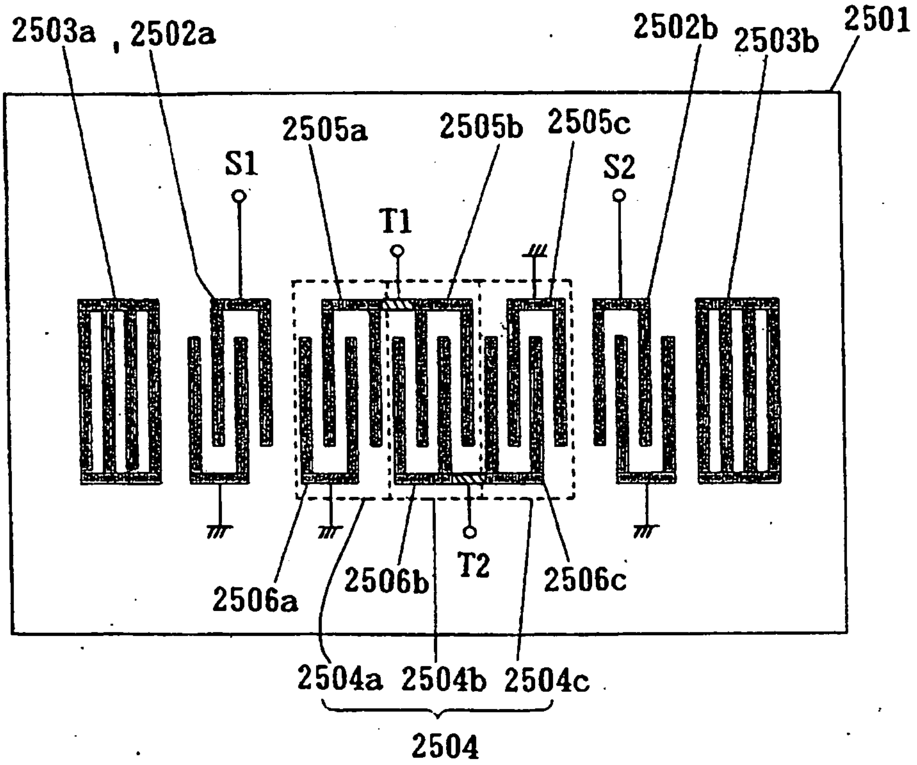
2503a
2502a
2502b
2503b
2501
2505a
2505b
2505c
S1
S2
T1
T2
2506a
2506b
2506c
2504a
2504b
2504c
2504

Fig. 8

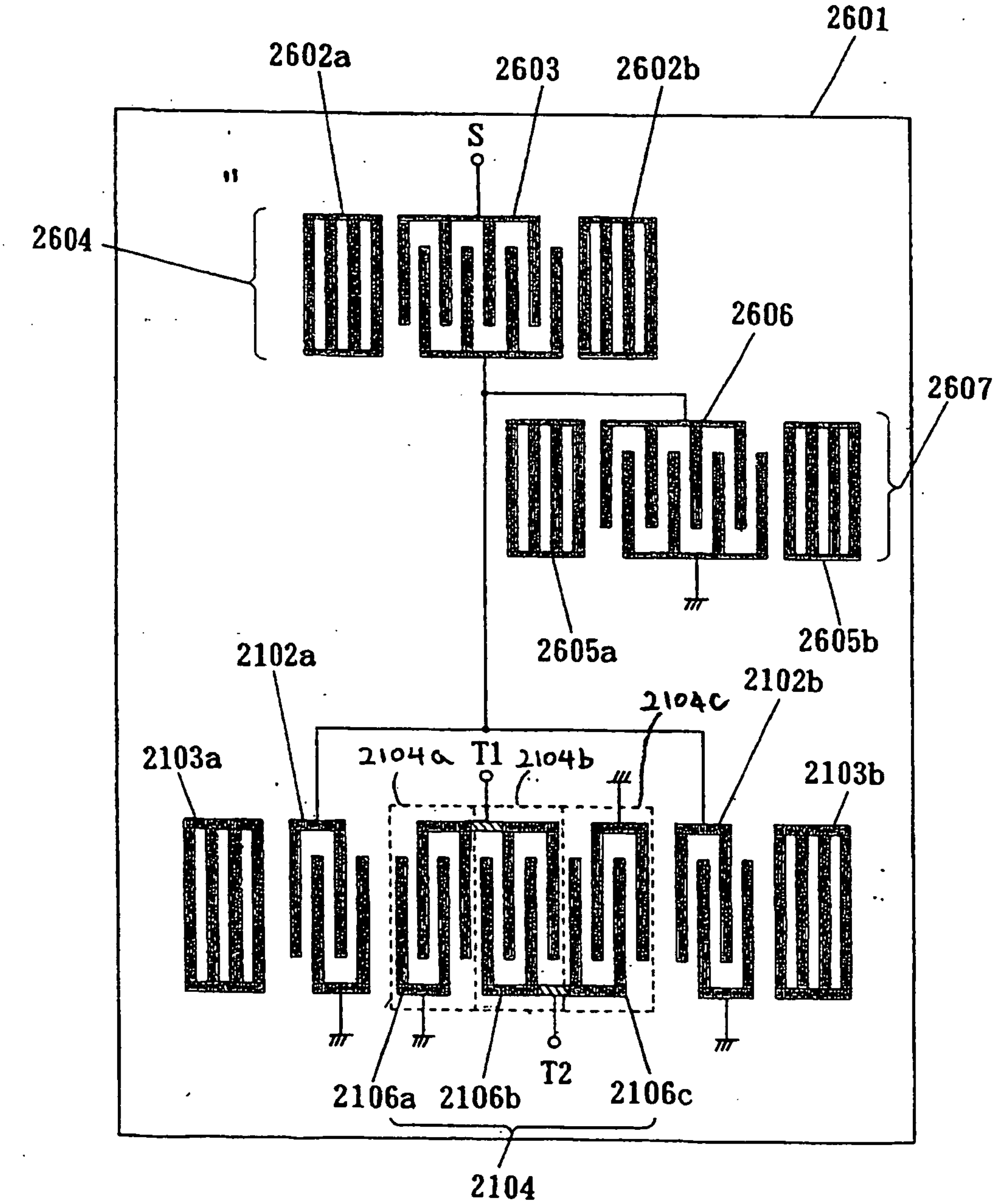
2601
2602a
2603
2602b
S
2604
2606
2607
2605a
2605b
2102a
2102b
2104c
2103a
2104a
T1
2104b
2103b
2106a
2106b
T2
2106c
2104

Fig. 9 (a)

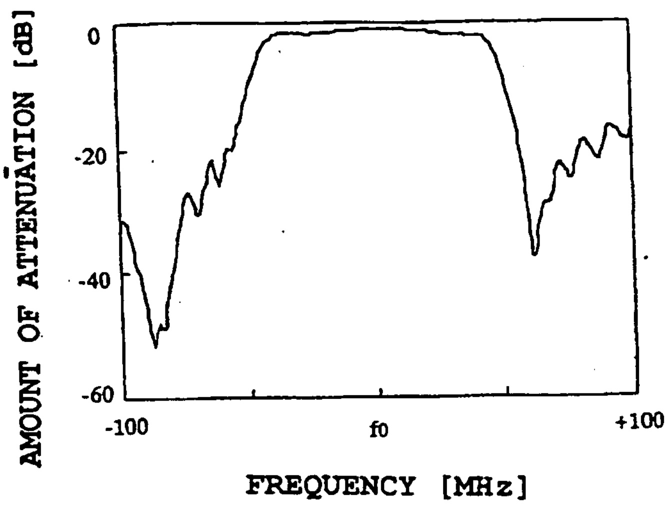
AMOUNT OF ATTENUATION [dB]
0
-20
-40
-60
-100
f0
+100
FREQUENCY [MHz]

Fig. 9 (b)

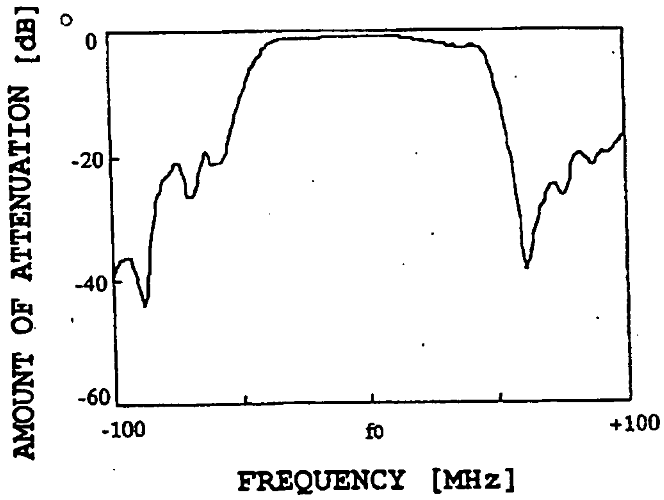
AMOUNT OF ATTENUATION [dB]
0
-20
-40
-60
-100
f0
+100
FREQUENCY [MHz]

Fig. 10

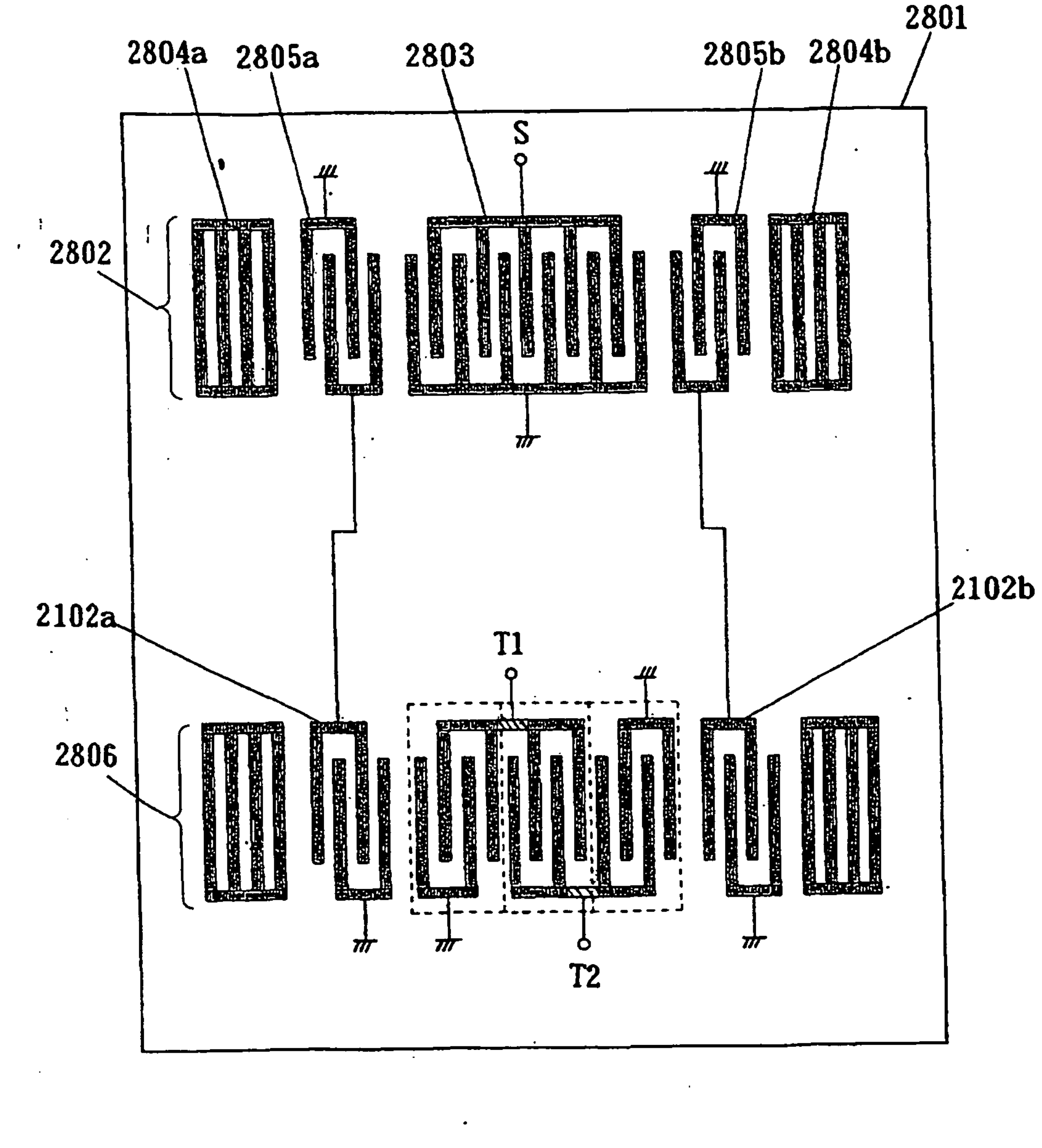
2801
2804a
2805a
2803
2805b
2804b
S
2802
2102a
2102b
T1
2806
T2

Fig. 11

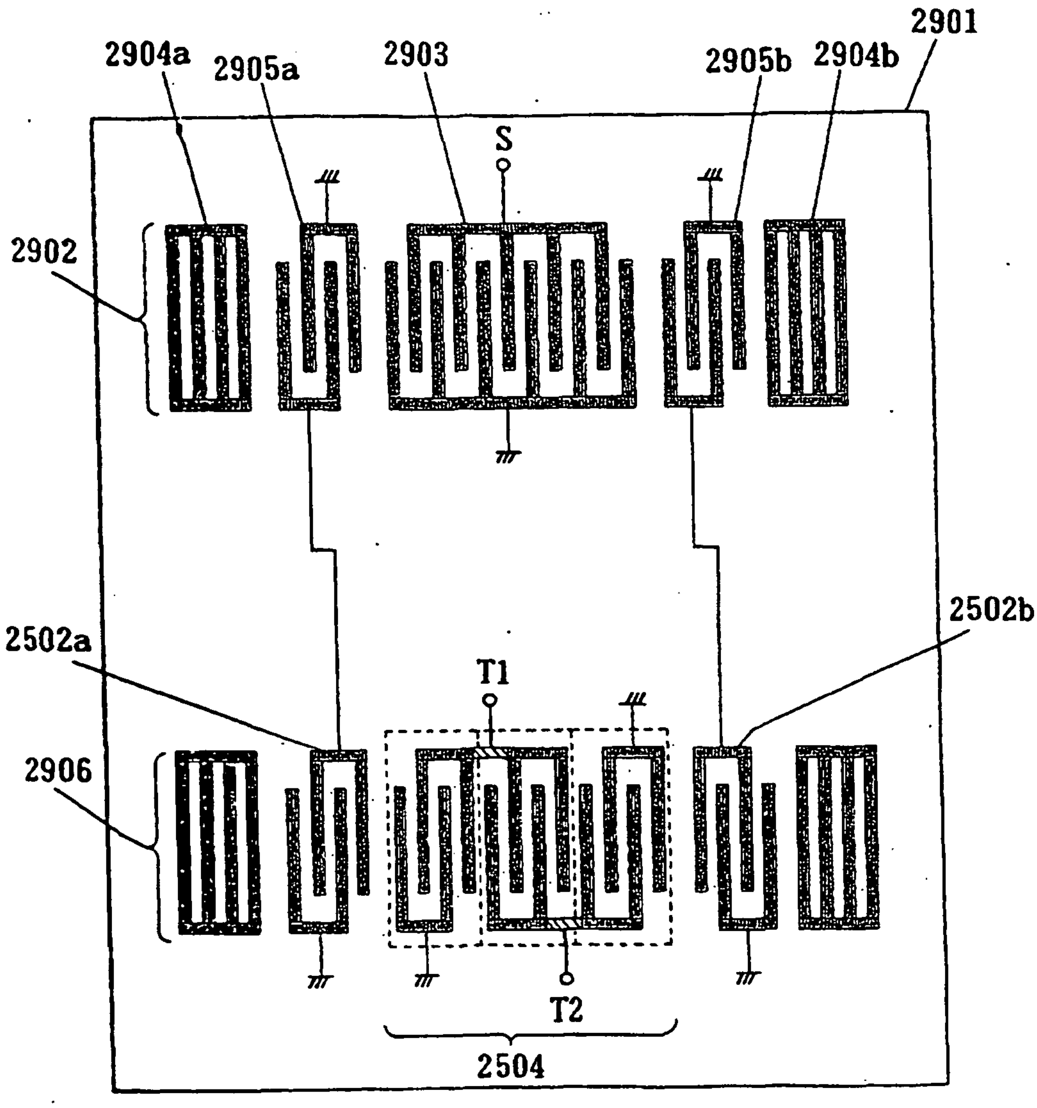
2901
2904a
2905a
2903
2905b
2904b
S
2902
2502a
2502b
T1
2906
T2
2504

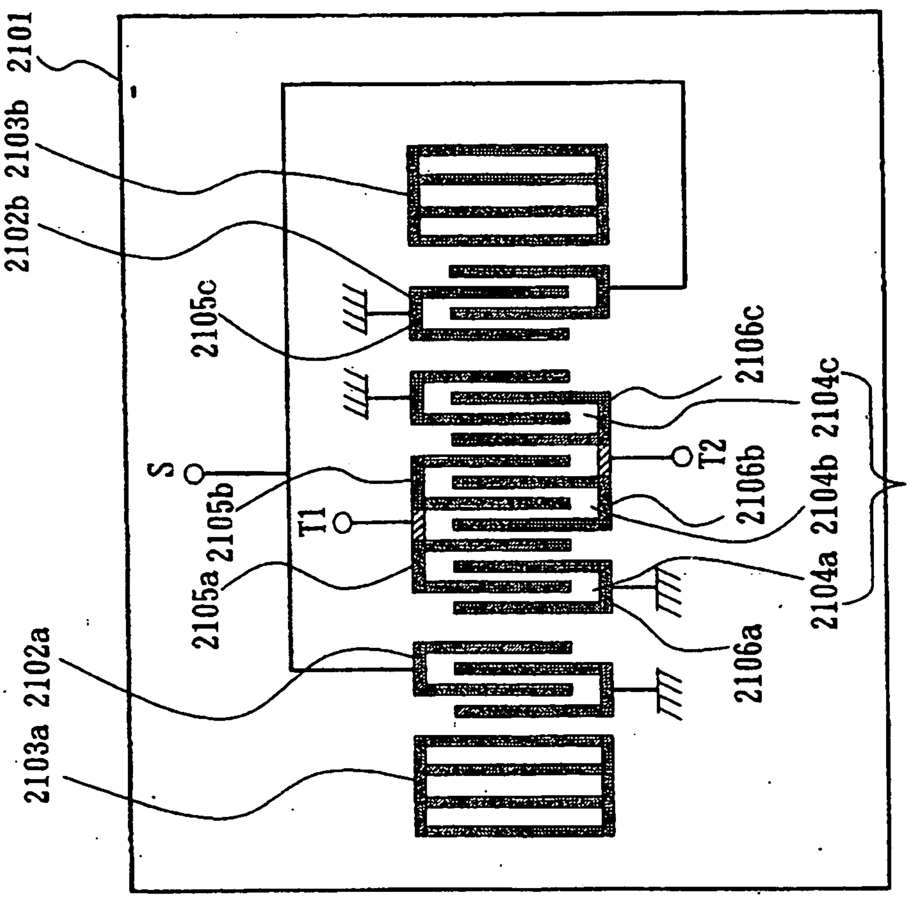
2101
2103b
2102b
2105c
S
2105b
T1
2105a
2102a
2103a
2106c
2104c
T2
2106b
2104b
2104
2104a
2106a

Fig. 12

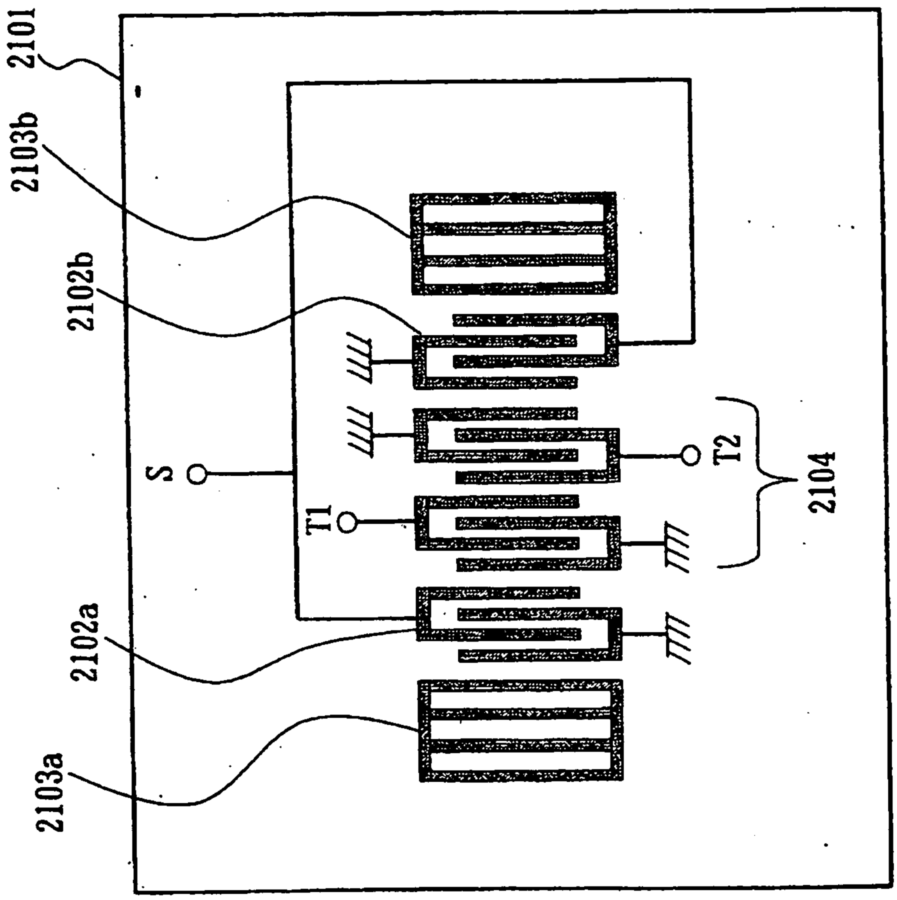


Fig. 13

Fig. 14 PRIOR ART

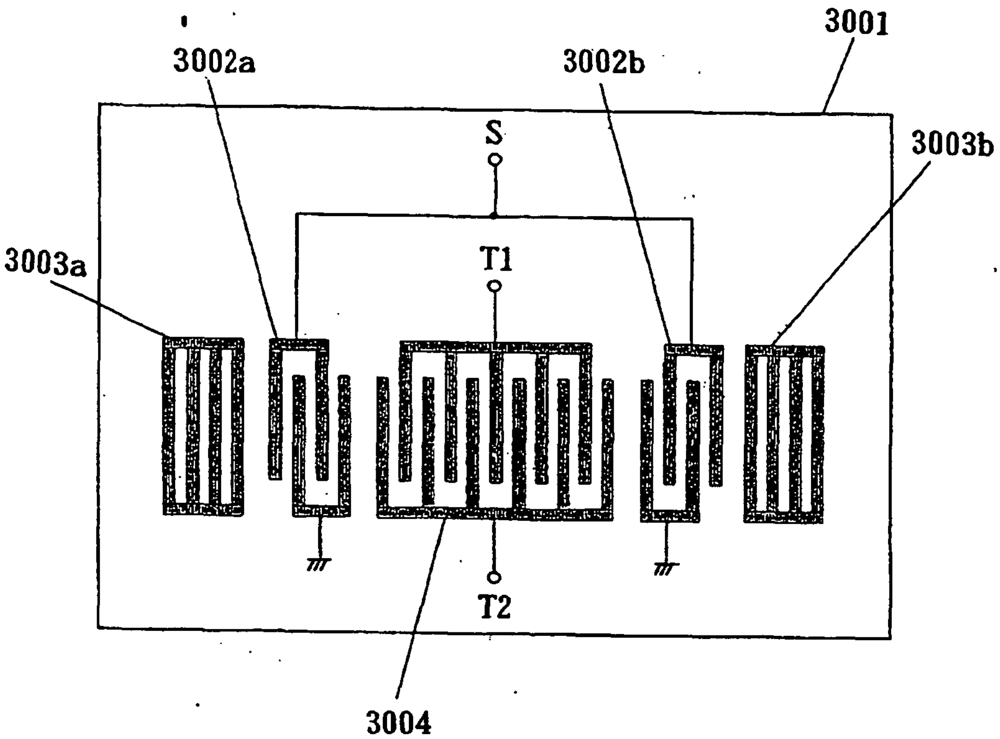

Fig. 15

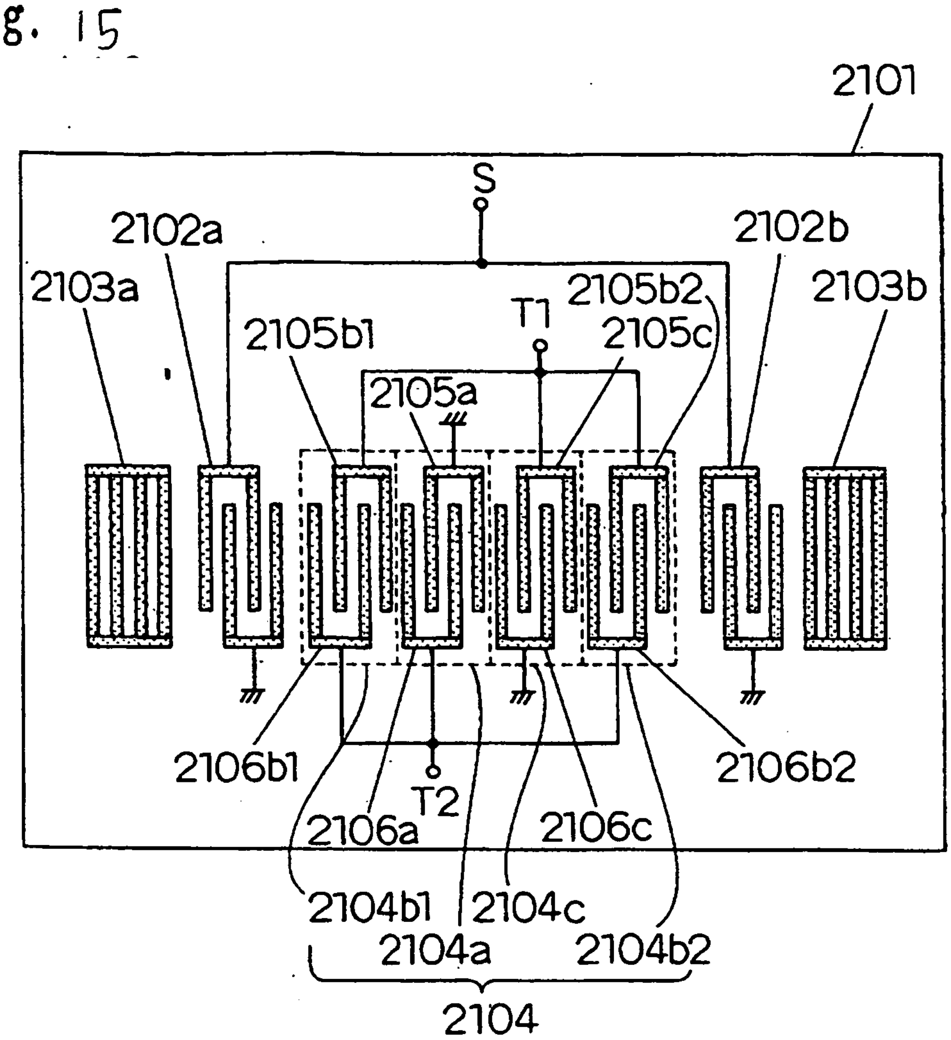
2101
S
2102a
2102b
2103a
2103b
2105b1
T1
2105b2
2105c
2105a
2106b1
2106b2
T2
2106a
2106c
2104b1
2104c
2104a
2104b2
2104

Fig. 16

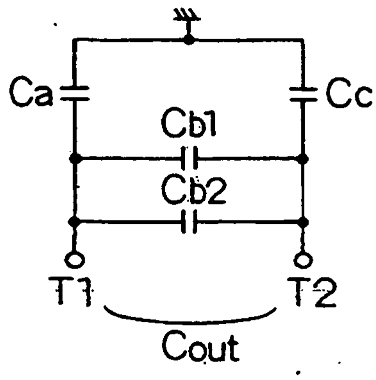
Ca
Cc
Cb1
Cb2
T1
T2
Cout

Fig. 17

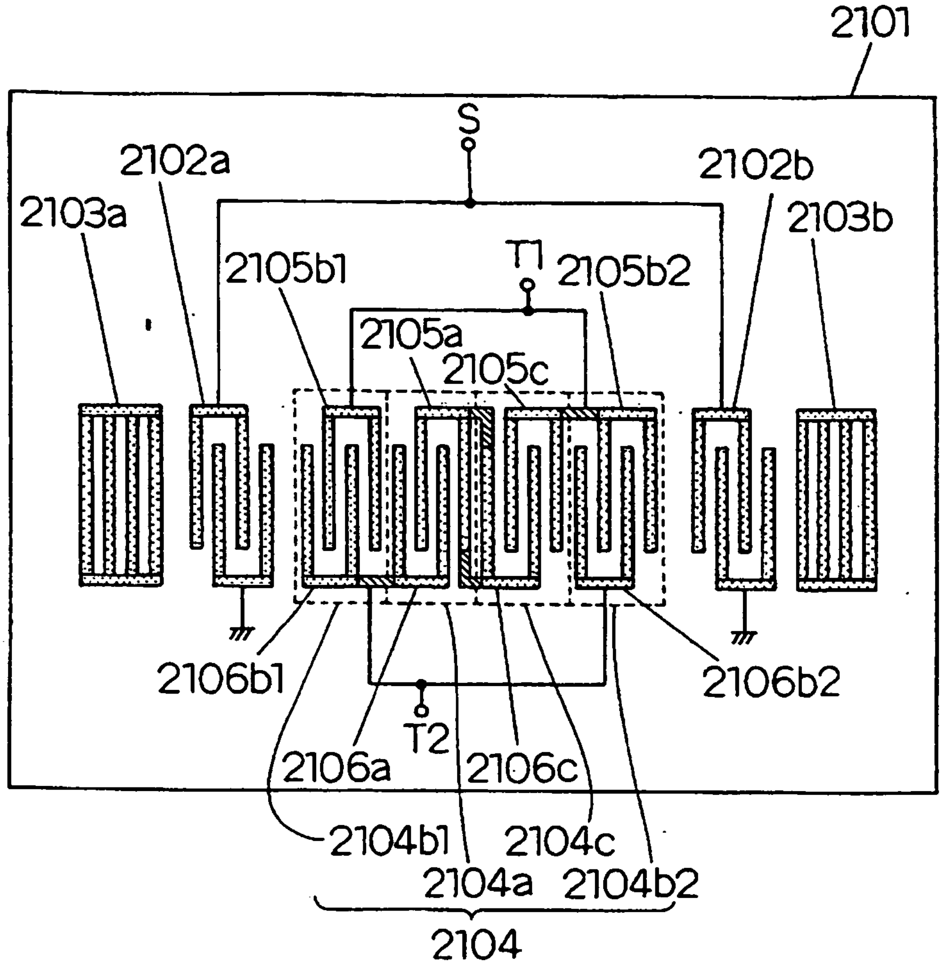
2101
S
2102a
2103a
2102b
2103b
2105b1
T1
2105b2
2105a
2105c
2106b1
2106b2
T2
2106a
2106c
2104b1
2104c
2104a
2104b2
2104

Fig. 18

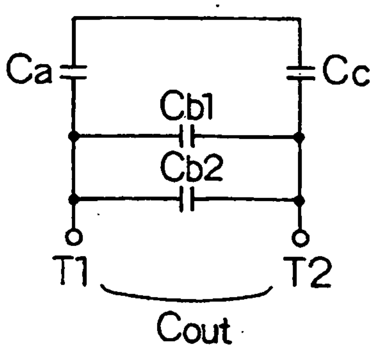
Ca
Cc
Cb1
Cb2
T1
T2
Cout

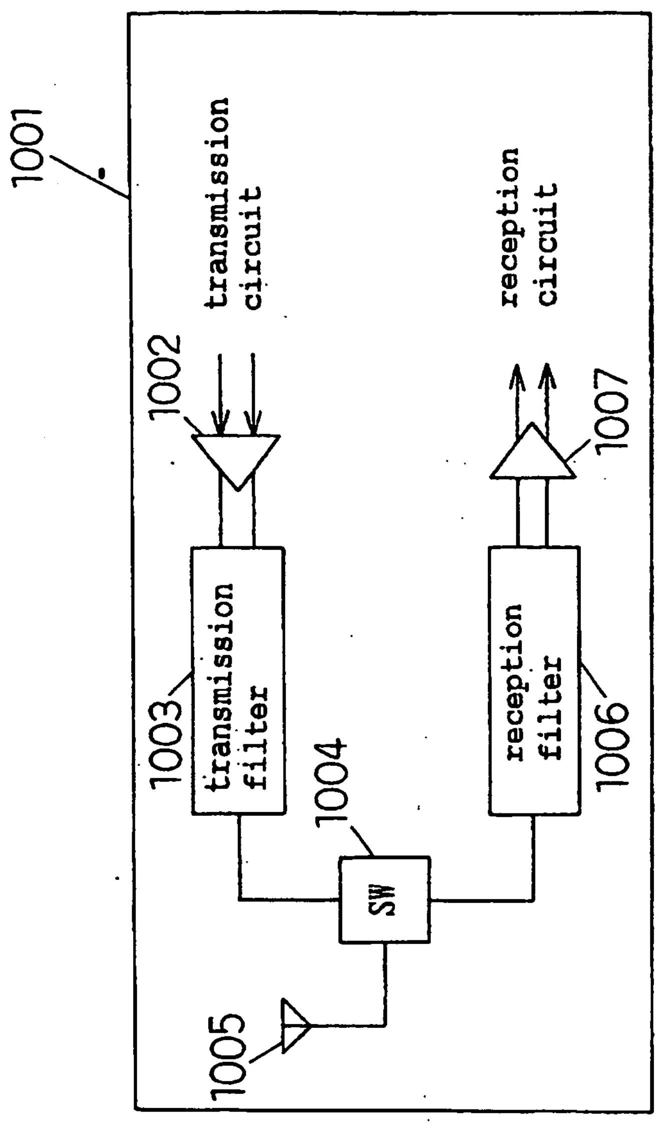
1001
transmission circuit
1002
1003
transmission filter
1004
SW
1005
reception circuit
1007
reception filter
1006

Fig. 19

Fig. 20 PRIOR ART

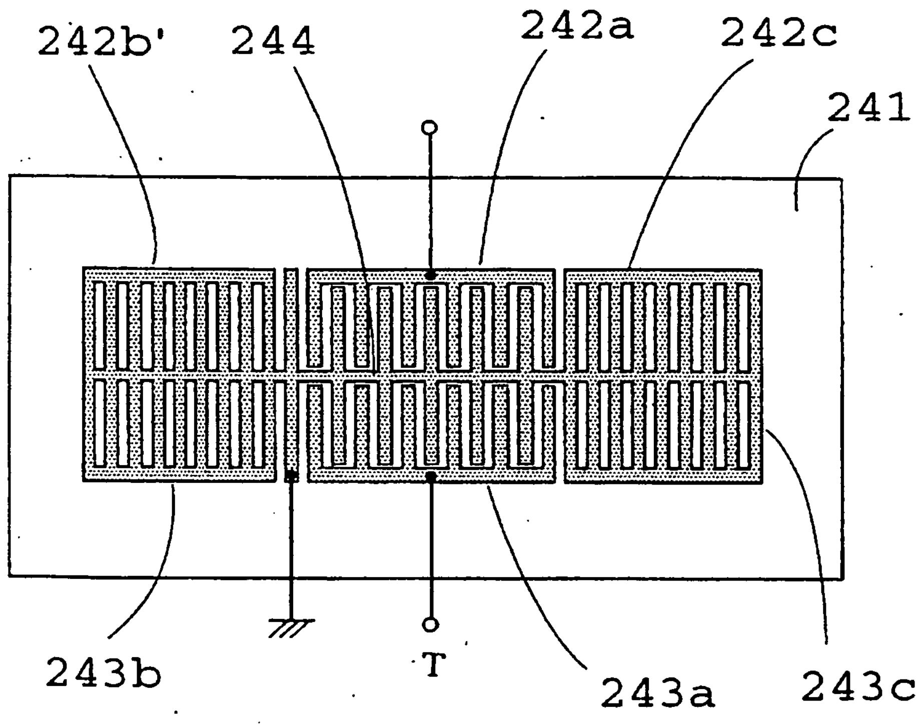

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 0809357 A